(19) Europäisches Patentamt
European Patent Office
Office européen des brevets

(11) **EP 4 576 573 A1**

(12) **DEMANDE DE BREVET EUROPEEN**

(43) Date de publication:
**25.06.2025 Bulletin 2025/26**

(21) Numéro de dépôt: **24222410.3**

(22) Date de dépôt: **20.12.2024**

(51) Classification Internationale des Brevets (IPC):
**H03H 9/05** (2006.01)     **H03H 9/02** (2006.01)

(52) Classification Coopérative des Brevets (CPC):
**H03H 9/0595; H03H 9/02338; H03H 9/0504**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **21.12.2023 FR 2314768**

(71) Demandeur: **Commissariat à l'Energie Atomique et aux Energies Alternatives**
**75015 Paris (FR)**

(72) Inventeurs:
• BIGOT, Emile
  **38054 GRENOBLE Cedex 09 (FR)**
• DESPESSE, Ghislain
  **38054 GRENOBLE Cedex 09 (FR)**

(74) Mandataire: **Hautier IP**
**20, rue de la Liberté**
**06000 Nice (FR)**

(54) **DISPOSITIF DE MAINTIEN POUR RÉSONATEUR PIÉZOÉLECTRIQUE ET CONVERTISSEUR DE PUISSANCE LE COMPRENANT**

(57)     L'invention concerne le domaine des convertisseurs de puissance, et plus particulièrement le domaine des dispositifs de maintien pour résonateur piézoélectrique notamment destiné à être employé en tant que composant inductif au sein des convertisseurs de puissance.

L'invention selon ses différents aspects propose un nouveau dispositif de maintien pour résonateur piézoélectrique permettant de minimiser l'énergie de déformation qui lui est transmise par le résonateur en fonctionnement, tout en permettant la reprise des connexions électriques au niveau des électrodes du résonateur. De plus, le dispositif de maintien proposé tend à réduire l'encombrement du système total, c'est-à-dire du résonateur dans son dispositif de maintien, ce qui est un enjeu crucial pour la réduction de volume souhaitée, en particulier lorsque le dispositif de maintien et le résonateur forment une partie au moins d'un convertisseur de puissance.

FIG. 4

EP 4 576 573 A1

**Description**

**DOMAINE TECHNIQUE**

La présente invention concerne le domaine des convertisseurs de puissance, et plus particulièrement le domaine des dispositifs de maintien pour résonateur piézoélectrique notamment destiné à être employé en tant que composant inductif au sein des convertisseurs de puissance.

**ETAT DE LA TECHNIQUE**

Les convertisseurs de puissance sont aujourd'hui omniprésents dans notre quotidien, ils permettent d'alimenter l'ensemble de nos dispositifs électroniques nomades ou non. On cherche toujours à les rendre à la fois plus petits et moins générateurs de pertes.

Pour ce faire, une des solutions proposées consiste à augmenter leur fréquence de fonctionnement afin de réduire le volume des composants de stockage d'énergie transitoire (c'est-à-dire les passifs). Cependant, des limites subsistent à cette montée en fréquence. Elles s'observent notamment du côté des composants à stockage magnétique qui possèdent des pertes fer intrinsèques et sont soumis au phénomène d'effet de peau ; les deux phénomènes empirant lorsque la fréquence augmente. Ceci nuit à l'amélioration de l'efficacité des convertisseurs de puissance.

Afin de dépasser ces limites, l'emploi de résonateurs piézoélectriques a été proposé. Ces résonateurs sont utilisés, aux fins de constituer des convertisseurs de puissance, entre leur fréquence de résonance et leur fréquence d'antirésonance sur un mode propre de leur structure (par exemple transversal (radial), longitudinal, ...). Entre ces deux fréquences, ils possèdent des caractéristiques similaires à celles des inductances magnétiques que l'on cherche à remplacer. Les modes de résonances exploités sont de nature mécanique. Ainsi, l'impact du dispositif de maintien du résonateur est à prendre en compte car celui-ci peut être à l'origine de fuites d'onde (donc de pertes), mais aussi d'apparition de nouveaux modes de résonances pouvant parasiter le système dans sa bande de fonctionnement. Il est alors crucial de trouver un système assurant à la fois un maintien mécanique correct du résonateur piézoélectrique et qui permet aussi une bonne connexion électrique nécessaire à l'emploi du résonateur piézoélectrique.

Aujourd'hui, on retrouve des résonateurs piézoélectriques dans l'automobile pour l'injection de carburants, pour les pulvérisateurs d'eau, le nettoyage ultrason, le positionnement de précision, les générateurs de plasma, mais aussi dans le monde des télécommunications pour la réalisation de filtres radiofréquences. Dans ce dernier cas d'usage, les résonateurs sont régulièrement amenés à travailler sur l'ensemble de la bande située entre leur fréquence de résonance et leur fréquence d'antirésonance sur un mode de résonance sélectionné, ce qui est moins le cas pour les autres applications. C'est pourquoi l'état de l'art discuté ci-dessous se consacre aux solutions développées pour la réalisation de filtres radiofréquences.

Il est par exemple connu, du document de brevet référencé EP1041714 A2, un dispositif de maintien d'un résonateur piézoélectrique fonctionnant sur un mode longitudinal. Le maintien est réalisé au moyen d'une jonction mécanique en un matériau (référencé 40 sur la figure 4 du document de brevet EP1041714 A2) possédant une impédance acoustique significativement différente de celle du résonateur. De plus, des points d'ancrage (référencés 40a sur la figure 4 du document de brevet EP1041714 A2), entre le résonateur et le dispositif de maintien, sont situés à peu de chose près au droit du centre du résonateur. Physiquement, ces points d'ancrage correspondent aux points où les déplacements de matière sont quasiment nuls, mais où la contrainte est maximale pour le mode longitudinal qui est adressé par ce brevet.

Cette solution technique est intéressante, car elle permet de confiner l'onde acoustique sans avoir besoin de dimensionner de quelconques éléments ; il suffit simplement de réaliser la jonction mécanique centrale proposée en un matériau conducteur possédant des propriétés acoustiques différentes de celle du résonateur fixé. Ainsi, l'onde de déformation, d'amplitude faible car au centre du matériau, est réfléchie en grande partie entre d'une part le résonateur et le substrat (référencé 12 sur la figure 4 du document de brevet EP1041714 A2) et d'autre part le matériau constitutif de la jonction mécanique.

Cependant, la jonction mécanique entre le résonateur et son support est ponctuelle. De fait, la résistance mécanique de l'ensemble est mauvaise et ce type de solutions trouve à s'appliquer pour des résonateurs de petites dimensions possédant une masse faible.

Dans le cas de la conversion de puissance, on veut pouvoir utiliser des résonateurs massifs afin de stocker en leur sein un maximum d'énergie (qui dépend du volume de matière employée). Ce type de support ne parait donc pas assez robuste. De plus, dans certaines applications, une intégration purement planaire pourrait être désirée ce qui n'est pas possible avec le type de jonction mécanique que divulgue le document de brevet EP1041714 A2. Il faut par ailleurs trouver un moyen de connexion électrique annexe pour accéder au potentiel supérieur du résonateur piézoélectrique.

Il est également connu, du document de brevet référencé CN109546986, un support de résonateur piézoélectrique pour des microsystèmes électromécaniques, ci-dessous MEMS, employés en radiofréquence. Le support est tel qu'il met en oeuvre des structures d'attache très peu raides pour maintenir le résonateur piézoélectrique. Afin de minimiser l'énergie transmise au support, le résonateur piézoélectrique, en position centrale, fonctionne sur un mode tel qu'il exhibe des noeuds aux niveaux de ses points d'ancrage sur le support.

Cette solution est employée lorsque la dimension des éléments souples du support devient trop faible pour être usinée directement sous forme de barres droites (ce qui est le cas des résonateurs à très haute fréquence). En proposant des formes spécifiques pour ces éléments souples, leur raideur de maintien est diminuée et l'énergie transmise par le résonateur au support l'est aussi.

Cependant, on remarque que le support proposé utilise une surface très importante ce qui n'est pas désiré, en particulier pour la conversion de puissance. De plus, afin d'être efficace et de minimiser les pertes, le support impose la génération de noeuds à la périphérie du résonateur piézoélectrique. Par conséquence, comme le résonateur ne travaille pas sur un mode premier, il perd en capacité à échanger de l'énergie, ce qui n'est pas avantageux lorsque l'on souhaite développer une solution dont la principale application consiste en une conversion de puissance.

Une autre solution, visant à minimiser les pertes de maintien d'un résonateur piézoélectrique dans le cas de la réalisation de MEMS employés en radiofréquence, est décrite dans l'article scientifique de B.P. Harrington et al., intitulé « In-plane acoustic reflectors for reducing effective anchor loss in lateral-extensional MEMS resonators », et paru dans J. Micromech. Microeng. 21 (2011) 085021. Afin de confiner l'onde de déformation produite par le résonateur piézoélectrique, un dispositif de maintien du résonateur est proposé qui comprend des tranchées en arc de cercle réalisées sur ses bords de maintien. Ces tranchées possèdent des dimensions caractéristiques proches de la demi-longueur d'onde de déformation d'excitation, de sorte à former un réflecteur pour confiner l'onde de déformation. Ce faisant, au niveau du premier point de maintien avec le résonateur, un quasi-noeud est généré ; ensuite, lorsque l'onde se propage vers le réflecteur, la majeure partie de celle-ci est renvoyée vers le point de fixation avec le résonateur. Lors de sa réflexion, l'onde se retrouve déphasée de $\pi$ (ou 180°). Si la taille caractéristique est telle que l'onde réfléchie forme un noeud de déplacement sur le bord du réflecteur, l'onde réfléchie est renvoyée en phase avec la première ; ainsi, le réflecteur se retrouve à accompagner le résonateur dans sa déformation ce qui minimise les pertes dues au maintien du résonateur.

Finalement, la zone où le réflecteur acoustique est lié avec le reste du bâti constitue un endroit où des fuites d'ondes continuent de se disperser. Les bienfaits du réflecteur sont tout de même considérables, avec, d'après les auteurs, un gain de 560% sur le facteur de qualité mécanique de l'ensemble constitué du résonateur et de son support.

Ce dispositif de maintien est intéressant car il est plus compact que celui décrit dans le document de brevet référencé CN109546986, et ce de par sa reprise de maintien sur le côté. Cependant, on constate que la surface totale nécessaire au maintien reste très importante avec une occupation proche de 1,5 fois la surface du résonateur employé. Enfin, le substrat piézoélectrique ne devant pas être excité sur les parties hors du résonateur, il est nécessaire d'avoir des électrodes supérieure (top) et inférieure (bottom) qui ne se superposent pas sur les parties de fixation, ce qui réduit la largeur du plan de connexion électrique au résonateur qui, dans le cas d'emploi pour la conversion de puissance, a besoin d'être maximisée afin de réduire les impédances électriques de connexions (aussi bien résistives qu'inductives). Aussi, le dispositif de maintien selon B.P. Harrington *et al.* suppose des noeuds à déplacement nul sur la périphérie du résonateur pour minimiser l'énergie transmise au support.

Il subsiste donc un besoin en termes de moyens de tenue mécanique robuste du résonateur qui laissent le résonateur vibrer sans introduire de pertes et/ou de modes parasites, notamment entre sa fréquence de résonance et sa fréquence d'antirésonance, sur le mode de vibration sélectionné.

Plus particulièrement, un objet de la présente invention est de développer un dispositif de maintien pour résonateur piézoélectrique adapté aux contraintes induites par l'application ou les applications visées, dont notamment la conversion de puissance.

## RESUME

Pour atteindre cet objectif, selon un premier aspect de l'invention, on prévoit un dispositif de maintien pour résonateur piézoélectrique, le dispositif de maintien comprenant au moins deux cellules élémentaires destinées à être liées mécaniquement entre elles et à être réparties sur un pourtour, intérieur ou extérieur, du résonateur piézoélectrique, au moins une, de préférence chaque, cellule élémentaire comprenant quatre barreaux dont :

- un barreau dit primaire par lequel le dispositif de maintien est destiné à être lié mécaniquement au résonateur piézoélectrique,
- deux barreaux dits secondaires, dont :

  ◦ un premier barreau secondaire :

    - lié mécaniquement au barreau primaire de la cellule élémentaire considérée,
    - lié mécaniquement à une cellule élémentaire adjacente à la cellule élémentaire considérée, et
    - destiné à être lié mécaniquement à un bâti extérieur, et

◦ un second barreau secondaire :

- lié mécaniquement au barreau primaire de la cellule élémentaire considérée,
- lié mécaniquement à une cellule élémentaire adjacente à la cellule élémentaire considérée, et
- destiné à être lié mécaniquement au bâti extérieur, et

◦ un barreau dit tertiaire liant mécaniquement entre eux le premier barreau secondaire et le second barreau secondaire de la cellule élémentaire considérée.

Selon un deuxième aspect de l'invention, on prévoit un ensemble comprenant un dispositif de maintien tel qu'introduit ci-dessus et au moins un résonateur piézoélectrique.
Selon un troisième aspect de l'invention, on prévoit un convertisseur de puissance comprenant un ensemble tel qu'introduit ci-dessus.
Selon un quatrième aspect de l'invention, on prévoit un procédé de dimensionnement d'un dispositif de maintien tel qu'introduit ci-dessus, comprenant :

- dimensionner au moins un, de préférence chaque, barreau primaire d'au moins une, de préférence de chaque, cellule élémentaire de sorte que, avec un résonateur piézoélectrique configuré pour vibrer dans une bande de fréquence déterminée, le barreau primaire est en résonance, à 20% près, avantageusement à 10% près, avec les vibrations du résonateur piézoélectrique pour une fréquence d'excitation quelconque située dans ladite bande de fréquence déterminée, et/ou
- dimensionner au moins l'un, de préférence chacun, parmi les premier et second barreaux secondaires d'au moins une, de préférence de chaque, cellule élémentaire de sorte qu'il présente une longueur sensiblement égale à un multiple d'une demi-longueur d'onde pour une fréquence d'excitation choisie située dans la bande de fréquence déterminée, et de préférence en son centre, ou son centre géométrique, et présentent, par rapport à leur axe longitudinal, un moment quadratique au moins quatre fois supérieur, de préférence au moins dix fois supérieur, à un moment quadratique du barreau primaire par rapport à son axe longitudinal, et/ou
- dimensionner le barreau tertiaire d'au moins une, de préférence de chaque, cellule élémentaire, de sorte qu'il présente une longueur sensiblement égale à la longueur du barreau primaire de la cellule élémentaire considérée, une épaisseur supérieure, de préférence au moins deux fois supérieure, à une épaisseur du barreau primaire de la cellule élémentaire considérée, et est avantageusement adapté en impédance mécanique avec les premier et second barreaux secondaires de la cellule élémentaire considérée.

Ainsi, l'invention selon ses différents aspects propose un nouveau dispositif de maintien pour résonateur piézoélectrique permettant de minimiser l'énergie de déformation qui lui est transmise par le résonateur en fonctionnement, tout en permettant la reprise des connexions électriques au niveau des électrodes du résonateur. De plus, le dispositif de maintien proposé tend à réduire l'encombrement du système total, c'est-à-dire du résonateur dans son dispositif de maintien, ce qui est un enjeu crucial pour la réduction de volume souhaitée, en particulier lorsque le dispositif de maintien et le résonateur forment une partie au moins d'un convertisseur de puissance.

**BREVE DESCRIPTION DES FIGURES**

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente schématiquement une vue en coupe d'un mode de réalisation d'une cellule élémentaire d'un dispositif de maintien selon le premier aspect de l'invention et une partie du résonateur piézoélectrique que la cellule équipe.
La figure 1A représente un agrandissement de la partie de la figure 1 qui est encadrée par un trait en tirets long-courts.
La figure 2 représente schématiquement une vue partielle en coupe d'un mode de réalisation du dispositif de maintien selon le premier aspect de l'invention et une partie du résonateur piézoélectrique que le dispositif de maintien équipe.
La figure 3 représente schématiquement la vue partielle en coupe d'un mode de réalisation du dispositif de maintien selon le premier aspect de l'invention qui est illustré sur la figure 2 et y ajoute des illustrations graphiques destinées essentiellement à montrer comment des ondes transverses se propagent dans le milieu de propagation que constitue le dispositif de maintien.
La figure 4 représente schématiquement une vue de dessus d'un résonateur piézoélectrique prenant la forme d'un disque et d'un mode de réalisation du dispositif de maintien selon le premier aspect de l'invention qui équipe ledit résonateur piézoélectrique.

La figure 5 représente schématiquement une vue de dessus d'un ensemble de résonateurs piézoélectriques de forme carrée et d'un ensemble de dispositifs de maintien selon le premier aspect de l'invention qui permettent une mise en matrice dudit ensemble de résonateurs piézoélectriques.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différents éléments constitutifs de l'invention selon son premier aspect ne sont pas nécessairement représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :

Selon un exemple du premier aspect de l'invention, au moins un, de préférence chaque, barreau primaire d'au moins une, de préférence de chaque, cellule élémentaire est de dimensions telles que, avec un résonateur piézoélectrique configuré pour vibrer dans une bande de fréquence déterminée, le barreau primaire est en résonance, à 20% près, avantageusement à 10% près, avec les vibrations du résonateur piézoélectrique pour une fréquence d'excitation quelconque située dans ladite bande de fréquence déterminée. Que le barreau primaire soit en résonance à 20% près, avantageusement 10% près, avec les vibrations du résonateur piézoélectrique signifie qu'un décalage de fréquence est autorisé entre la fréquence propre du barreau primaire au point d'accroche avec le résonateur piézoélectrique si le résonateur piézoélectrique n'était pas accroché et la fréquence de vibration du résonateur piézoélectrique qui peut être quelconque dans la bande de fréquence déterminée. Selon l'exemple précédent, la bande de fréquence déterminée est sensiblement comprise au plus entre une fréquence de résonance et une fréquence d'antirésonance du résonateur piézoélectrique sur un mode de résonance sélectionné.

Selon un exemple du premier aspect de l'invention, au moins l'un, de préférence chacun, parmi les premier et second barreaux secondaires d'au moins une, de préférence de chaque, cellule élémentaire est de dimensions telles qu'il présente une longueur sensiblement égale à un multiple d'une demi-longueur d'onde pour une fréquence d'excitation choisie située dans la bande de fréquence déterminée, et de préférence en son centre ou en son centre géométrique, et présentent, par rapport à leur axe longitudinal, un moment quadratique au moins quatre fois supérieur, de préférence au moins dix fois supérieur, à un moment quadratique du barreau primaire par rapport à son axe longitudinal.

Selon un exemple du premier aspect de l'invention, le barreau tertiaire d'au moins une, de préférence de chaque, cellule élémentaire, est de dimensions telles qu'il présente une longueur sensiblement égale à la longueur du barreau primaire de la cellule élémentaire considérée, une épaisseur supérieure, de préférence au moins deux fois supérieure, à une épaisseur du barreau primaire de la cellule élémentaire considérée, et est avantageusement adapté en impédance mécanique avec les premier et second barreaux secondaires de la cellule élémentaire considérée.

Selon un exemple du premier aspect de l'invention, la cellule élémentaire à laquelle le premier barreau secondaire de la cellule considérée est lié mécaniquement est différente de celle à laquelle le second barreau secondaire de la cellule considérée est lié mécaniquement ; le dispositif de maintien comprend alors au moins trois cellules élémentaires.

Selon un exemple du premier aspect de l'invention, lesdites au moins deux cellules élémentaires sont destinées à être réparties sur le pourtour du résonateur piézoélectrique en formant une structure refermée sur elle-même, la cellule élémentaire qui est liée mécaniquement au premier barreau secondaire de la cellule élémentaire considérée, est adjacente, dans ladite structure refermée, à la cellule élémentaire considérée, et la cellule élémentaire qui est liée mécaniquement au second barreau secondaire de la cellule élémentaire considérée, est adjacente, dans ladite structure refermée, à la cellule élémentaire considérée, les cellules élémentaires liées mécaniquement à la cellule élémentaire considérée pouvant être différentes entre elles.

Selon un exemple du premier aspect de l'invention, le barreau primaire est dimensionné de sorte à résonner dans un mode premier, par exemple transversal ou longitudinal, à 20% près, avantageusement à 10% près, pour ladite fréquence quelconque située dans la bande de fréquence déterminée. Le dispositif de maintien est ainsi mieux adapté à un usage du résonateur comme convertisseur de puissance.

Selon un exemple du premier aspect de l'invention, au moins un barreau, de préférence chaque barreau, parmi les quatre barreaux est constitué à base d'au moins un matériau, de préférence isotrope, choisi parmi :

- un métal, tel que le laiton ou le cuivre,
- du plastique,
- une céramique,
- un composite de résine époxy renforcé de fibres de verre, tel que du FR-4, et

- un cristal.

Selon un exemple du premier aspect de l'invention, alternatif au précédent, au moins un barreau, de préférence chaque barreau, parmi les quatre barreaux comprend un matériau isolant et une ou plusieurs fines couches métalliques séparées par le matériau isolant, par exemple une plaque pour circuit imprimé. Le dispositif de maintien selon cet exemple bénéficie de ce qu'une plaque pour circuit imprimé est peu chère et/ou de ce que l'utilisation d'une plaque pour circuit imprimé pour fabriquer le dispositif de maintien selon le premier aspect de l'invention permet d'utiliser les couches fines métalliques, le cas échéant usinées, pour permettre aisément une reprise de contacts électriques fonctionnelle notamment pour piloter le fonctionnement du résonateur piézoélectrique.

Selon un exemple du premier aspect de l'invention, alternatif aux deux précédents, au moins un barreau, de préférence chaque barreau, est constitué à base du même matériau piézoélectrique, de préférence isotrope transverse, que celui dans lequel est destiné à être constitué le résonateur piézoélectrique. Le dispositif de maintien selon cet exemple peut avantageusement ne constituer qu'une seule pièce ou une pièce d'un seul tenant avec le résonateur électrique.

Selon un exemple du premier aspect de l'invention, le barreau primaire est destiné à être lié mécaniquement au résonateur piézoélectrique en un premier point de liaison situé sensiblement entre une première extrémité et une seconde extrémité du barreau primaire.

Selon un exemple du premier aspect de l'invention, le barreau primaire est destiné à être lié mécaniquement au résonateur piézoélectrique par l'intermédiaire d'un ergot, la masse de l'ergot étant le cas échéant pris en compte pour le dimensionnement du barreau primaire.

Selon un autre exemple du premier aspect de l'invention, le barreau primaire présente une symétrie par rapport à un axe normal au pourtour du résonateur autour du point d'accroche.

Selon un exemple du premier aspect de l'invention

- le premier barreau secondaire de la cellule élémentaire considérée est lié mécaniquement par une première de ses deux extrémités à la première extrémité du barreau primaire de la cellule élémentaire considérée, est lié mécaniquement par une seconde de ses deux extrémités à la fois à une deuxième extrémité du barreau secondaire d'une cellule élémentaire qui, parmi lesdites au moins deux cellules élémentaires, est adjacente à la cellule élémentaire considérée, et est destiné à être lié mécaniquement au bâti extérieur, et
- le second barreau secondaire de la cellule élémentaire considérée est lié mécaniquement par une première de ses deux extrémités à la seconde extrémité du barreau primaire de la cellule élémentaire considérée, est lié mécaniquement par une seconde de ses deux extrémités à la fois à une seconde extrémité du premier barreau secondaire d'une cellule élémentaire qui, parmi lesdites au moins deux cellules élémentaires, est adjacente à la cellule élémentaire considérée, et destiné à être lié mécaniquement au bâti extérieur.

Selon un exemple du premier aspect de l'invention, le barreau tertiaire de la cellule élémentaire considérée lie mécaniquement entre elles la première extrémité du premier barreau secondaire de la cellule élémentaire considérée et la première extrémité du second barreau secondaire de la cellule élémentaire considérée.

Selon un exemple du premier aspect de l'invention, le barreau tertiaire de chaque cellule élémentaire est situé au droit et à distance du barreau primaire de la cellule élémentaire considérée, et est destiné à être situé, relativement au pourtour extérieur ou intérieur du résonateur piézoélectrique qu'il contribue à maintenir, à une plus grande distance que le barreau primaire de la cellule élémentaire considérée.

Selon un exemple du premier aspect de l'invention, lesdites au moins deux cellules élémentaires sont réparties sur le pourtour du résonateur piézoélectrique de sorte que ce dernier en fonctionnant exerce une excitation de même amplitude à 20% près, de préférence à 10% près, et/ou de même phase, à 30° près, de préférence à 15° près.

Selon un exemple du premier aspect de l'invention, chaque barreau primaire présente une épaisseur au moins 10 fois supérieure à l'amplitude de déformation qu'il subit du fait du fonctionnement du résonateur piézoélectrique.

Selon un exemple du deuxième aspect de l'invention, le résonateur piézoélectrique de l'ensemble est constitué à base de PZT.

Selon un autre exemple du deuxième aspect de l'invention, le résonateur piézoélectrique de l'ensemble est constitué à base de LNO (Niobiate de Lithium).

Selon un exemple du troisième aspect de l'invention, le résonateur piézoélectrique est configuré pour vibrer dans au moins un de ses premiers modes de vibration, par exemple son mode de vibration transversal et/ou son mode de vibration longitudinal.

Selon un exemple du troisième aspect de l'invention, le résonateur piézoélectrique présente une fréquence de résonance et une fréquence d'antirésonance, différentes entre elles, et est configuré pour fonctionner entre sa fréquence de résonance et sa fréquence d'antirésonance.

On entend par un élément à base d'un matériau A, un élément comprenant ce matériau A et éventuellement d'autres matériaux.

**EP 4 576 573 A1**

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

On entend par une liaison mécanique entre deux éléments ou barreaux que ces deux éléments ou barreaux se contactent entre eux sans jeu mécanique en au moins un point ou zone de liaison ou de contact. De préférence, deux éléments ou barreaux liés mécaniquement entre eux se contactent directement entre eux ; auquel cas, on pourra parler de liaison mécanique directe, ou d'éléments ou barreaux directement liés mécaniquement entre eux. De la sorte, des contraintes mécaniques, notamment liées à un déplacement d'au moins un des deux éléments ou barreaux liés mécaniquement entre eux, se propagent à l'autre élément ou barreau, cette propagation de contraintes mécaniques dépendant, notamment de leur nature et leur amplitude, des designs (au moins forme et dimensions) des éléments ou barreaux concernés.

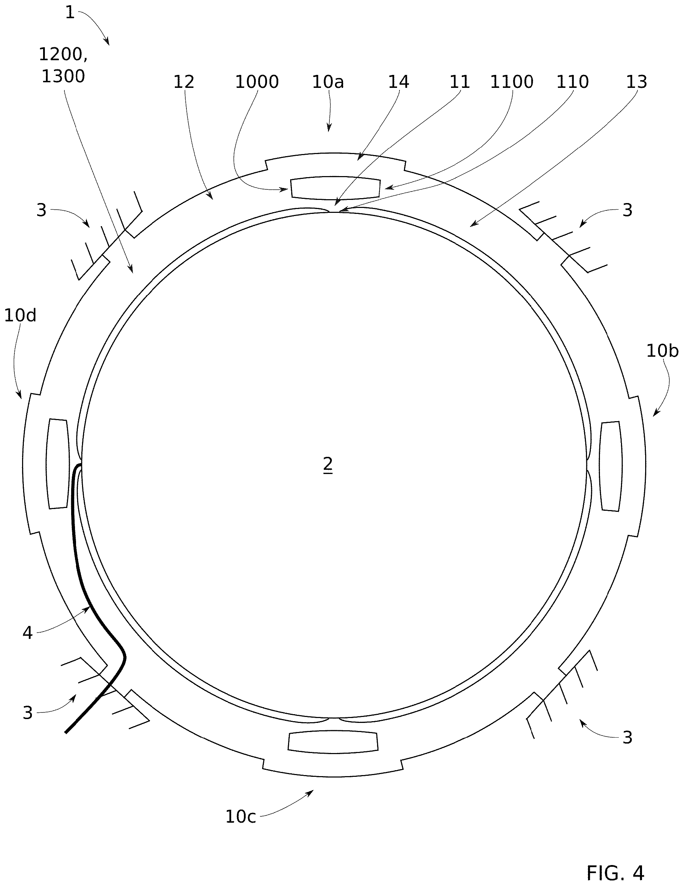

On entend, par noeuds de fonctionnement, des zones remarquables du dispositif de maintien selon le premier aspect de l'invention, qui sont non nécessairement ponctuelles, mais qui peuvent au contraire être étendues, leur extension restant cependant de dimensions faibles, par exemple dix fois inférieures, relativement aux dimensions des barreaux. Les noeuds de fonctionnement du dispositif de maintien selon le premier aspect de l'invention sont par exemple situés dans les zones qui, sur la figure 4, sont délimitées par les courbes ovales en tirets gras, chacune de ces zones comprenant un noeud de fonctionnement.

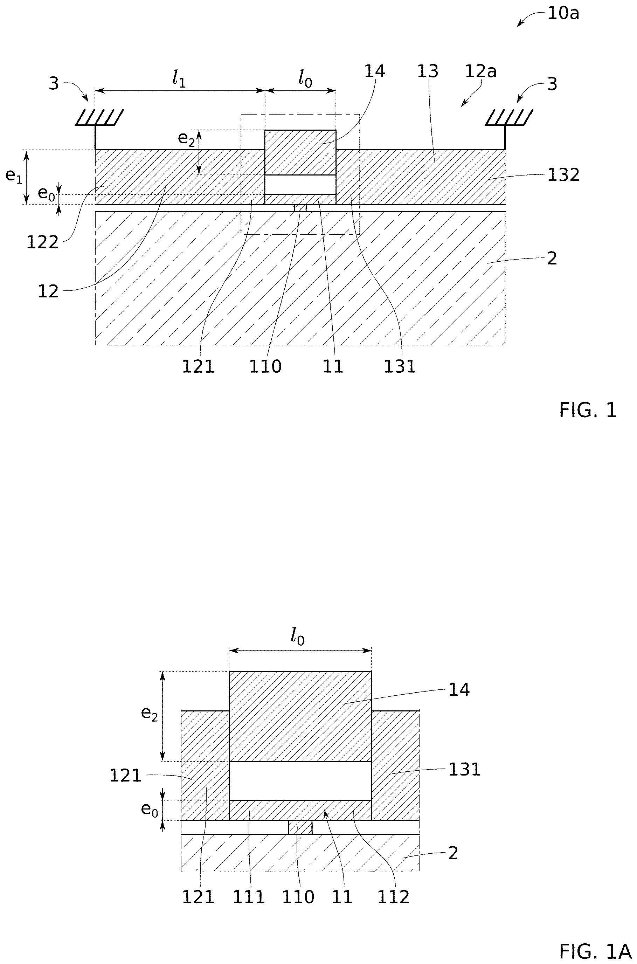

En référence aux figures 1 et 1A, un des objectifs poursuivis par la présente invention consiste à fournir un dispositif de maintien 1 (parfois appelé ci-dessous « fixation ») d'un résonateur piézoélectrique 2 sur un bâti extérieur (ou package) 3 qui soit adapté aux contraintes induites par certaines applications, et en particulier la conversion de puissance. Le dispositif de maintien 1 est plus particulièrement destiné à lier, ou encore à interfacer, mécaniquement le résonateur 2 et le bâti 3 entre eux. Le bâti 3 est de préférence fixe et indéformable sous des contraintes mécaniques qu'il peut subir du fait des déformations vibratoires du résonateur piézoélectrique 2 auquel il est mécaniquement lié via le dispositif de maintien 1. Ainsi, le dispositif de maintien 1 et le bâti 3 sont destinés à former ensemble, pour le résonateur 2, un support qualifiable d'opérationnel, en particulier relativement à une application visée du résonateur 2 et plus particulièrement de ses vibrations.

De préférence, le dispositif de maintien 1 doit être capable de maintenir au moins un résonateur 2, voire chaque résonateur 2 parmi une pluralité, en plusieurs points de liaison (ou de contact) 110. De la sorte, il est permis selon la présente invention d'isoler le résonateur piézoélectrique 2 de son environnement de travail 3 tout en conservant un taux de perte dû à l'ancrage du résonateur 1 relativement faible. Par conséquent, il est possible selon la présente invention de rendre le maintien du résonateur 2 isostatique/hyperstatique relativement à son support, ce qui n'est pas le cas des solutions de l'art antérieur. De plus, la taille du support 2 devrait idéalement être réduite au strict minimum de telle manière que la densité de puissance totale du résonateur 2 avec son dispositif de maintien 1 monté sur le bâti 3 puisse être maximisée, ce qui n'est pas le cas des solutions proposées par le document de brevet référencé CN 109546986 et par l'article de B.P. Harrington *et al.*.

De par sa nature, un résonateur piézoélectrique 2 génère, en fonctionnant, des ondes de déformation qui se propagent jusqu'au bâti 3 via le dispositif de maintien 1. En exploitant de manière correcte les ondes produites, l'énergie de déformation propagée au bâti 3 peut être réduite et donc les pertes liées à la propagation de ces ondes amoindries ; c'est ce que permet d'atteindre le dispositif de maintien 1 selon le premier aspect de la présente invention. De plus, de par la génération de noeuds de déplacement étendu aux interfaces de connexions entre le dispositif de maintien 1 et le bâti 3, une isolation mécanique du résonateur par rapport au bâti est obtenue. Ceci permettant d'éviter la mise en résonance d'élément du bâti pouvant provoquer une augmentation de l'absorption de l'énergie dans la bande de fréquence de travail.

Comme cela apparaîtra clairement ci-dessous, contrairement aux solutions de l'art antérieur, le dispositif de maintien 1 proposé ici n'impose pas un interfaçage entre le résonateur 2 et le bâti 3 sur des noeuds à déformations quasi nulles. Par conséquent, le résonateur 2 maintenu par le dispositif de maintien 1 selon la présente invention peut avantageusement travailler sur un de ses modes premiers de vibration, là où l'énergie échangeable est maximale, par exemple le mode transversal, ou plus particulièrement le mode radial, d'un résonateur prenant la forme d'un disque.

De plus, le dispositif de maintien 1 selon le premier aspect de l'invention permet de réduire les coûts de fabrication de l'ensemble comprenant le dispositif de maintien 1 et le résonateur piézoélectrique 2.

En outre, il est intéressant d'employer des formes de résonateurs 2 simples, aussi bien carrées que rectangulaires ou circulaires, ou en forme de disque ou d'anneaux.

Aussi, un usinage potentiellement complexe de la fixation 1 permettant de minimiser l'énergie transmise par le résonateur 2 au bâti 3 peut être couteuse à réaliser dans le matériau à base duquel le résonateur 2 est constitué. Dès lors, il est avantageux de pouvoir utiliser un matériau différent, moins coûteux et/ou plus facile à usiner, pour fabriquer le dispositif de maintien 1. Ces matériaux peuvent par exemple être du laiton, du cuivre, du plastique, une céramique, un composite de résine époxy renforcé de fibres de verre, tel que du FR-4 (pour « Flame Retardant 4 » en anglais), un cristal, etc.

En outre, le dispositif de maintien 1 comprenant au moins deux cellules élémentaires 10a, 10b et 10c destinées à être liées mécaniquement entre elles et à être réparties sur un pourtour, intérieur ou extérieur, du résonateur piézoélectrique 2, et au moins une, de préférence chaque, cellule élémentaire 10a, 10b, 10c comprenant quatre barreaux 11, 12, 13 et 14, ces derniers peuvent être constitués d'un même matériau ou de matériaux différents et/ou avoir des sections variées (aussi bien carrées que rectangulaires, circulaires, ...). Aussi, si les considérations ci-dessous portent essentiellement sur des barreaux de section rectangulaire et faits d'un même matériau, le dispositif de maintien 1 selon le premier aspect de l'invention n'est pas limité à cet exemple donné à titre illustratif.

Une cellule élémentaire 10a du dispositif de maintien 1 est schématisée sur la figure 1 qui illustre d'une part la liaison mécanique entre la cellule élémentaire 10a et le résonateur 2, d'autre part les liaisons mécaniques entre la cellule élémentaire 10a et le bâti 3. Sur la figure 1, le résonateur piézoélectrique 2 devant être maintenu n'est que partiellement représenté pour avoir une vue agrandie de cellule élémentaire 10a. Ensuite, pour généraliser, on considère un pourtour du résonateur 2 développé, sachant que la forme du résonateur 2 peut être ronde, carré, rectangle, ovale, celle d'un disque, celle d'un anneau ou tout autre. Sur la figure 1, la cellule élémentaire 10a est représentée droite, mais elle peut être courbée, par exemple pour suivre une forme arrondie du pourtour du résonateur 2.

Chaque cellule élémentaires 10a, 10b, 10c, etc. de la fixation 1 peut être vue comme constituée d'un assemblage de trois types de barreaux élémentaires vibrants, notés ci-dessous $B_{u0}$, $B_{u1}$ et $B_{u2}$, dont un barreau d'un premier type, dit barreau primaire 11, deux barreaux du deuxième type, dits barreaux secondaires 12 et 13, et un barreau d'un troisième type, dit barreau tertiaire 14. Les qualificatifs « primaire », « secondaire » et « tertiaire » permettent de discriminer les types de barreaux entre eux, et non à établir des niveaux d'importance relative entre types de barreaux.

Au niveau de chaque point de liaison 110, noté ci-dessous $a_u$, entre une cellule élémentaire 10a, 10b, 10c et le résonateur 2, la cellule élémentaire est liée mécaniquement avec le résonateur 2. En outre, chacun des bords de la cellule élémentaire 10a, soit chacune parmi des secondes extrémités 122 et 132 des barreaux $B_{u1}$, référencés 12 et 13 sur la figure 1, la cellule élémentaire 10a est liée au bâti 3. Ces liaisons mécaniques peuvent servir à implémenter le résonateur 2 et sa fixation 1 dans son environnement de travail comprenant le bâti 3.

Au moins deux cellules élémentaires sont réparties sur le pourtour du résonateur 2 à maintenir. Sur la figure 4, quatre dispositifs de maintien 1 sont représentés qui forment, comme nous le verrons plus bas, une structure refermée sur elle-même adaptée au pourtour circulaire d'un résonateur 2 prenant la forme d'un disque. Il est néanmoins envisagé qu'une telle structure refermée puisse être constituée de deux cellules élémentaires uniquement. Par exemple, partant de l'exemple illustré sur la figure 4. Il est envisagé qu'une structure refermée puisse être constituée de deux cellules qui, parmi les quatre représentées sur la figure 4, sont opposées entre elles.

Il est hautement préférable que, au niveau de tous les points de liaisons 110 entre les cellules élémentaires 10a, 10b, 10c et 10d et le résonateur 2, le résonateur exerce en fonctionnant sensiblement la même excitation. Pour satisfaire à cette préférence, nous verrons plus bas que, en fonction du design (forme et dimensions) du résonateur 2 à maintenir et du mode de vibration que l'on souhaite exploiter, un nombre minimum de cellules élémentaires à répartir sur le pourtour du résonateur 2 peut être grandement souhaité, voire imposé. Plus particulièrement, le résonateur 2 en fonctionnement exerce une excitation sensiblement de même amplitude, par exemple à 20% près, de préférence à 10% près, et/ou sensiblement de même phase, à 30° près (ou à 0.52 radians près), de préférence à 15° près. Par exemple, comme développé plus bas, pour un résonateur 2 prenant la forme d'un disque sur le pourtour circulaire duquel des cellules élémentaires 10a, 10b, 10c et 10d sont à répartir pour former le dispositif de maintien 1 selon le premier aspect de l'invention, il est préférable que les points de liaisons 110 entre la fixation 1 et le résonateur 2 soient sensiblement équirépartis, i.e. à équidistance du centre du résonateur 2 et à équidistance de leur(s) premier(s) voisin(s), par exemple à 20% près, de préférence à 10% près.

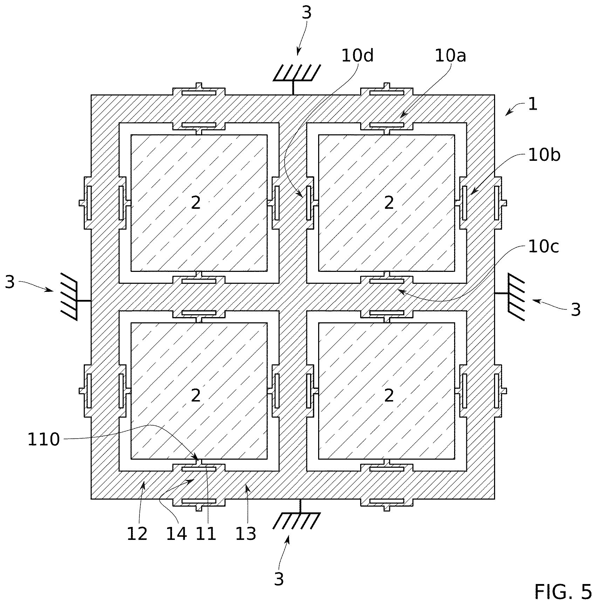

De préférence, en référence aux figures 4 et 5, le dispositif de maintien 1 comprend une pluralité de cellules élémentaires 10a, 10b, 10c et 10d, chacune comprenant, ou consistant, en un assemblage d'un barreau primaire 11, de deux barreaux secondaires 12 et 13 et d'un barreau tertiaire 14, répartis sur le pourtour du résonateur 2 en formant une structure refermée sur elle-même.

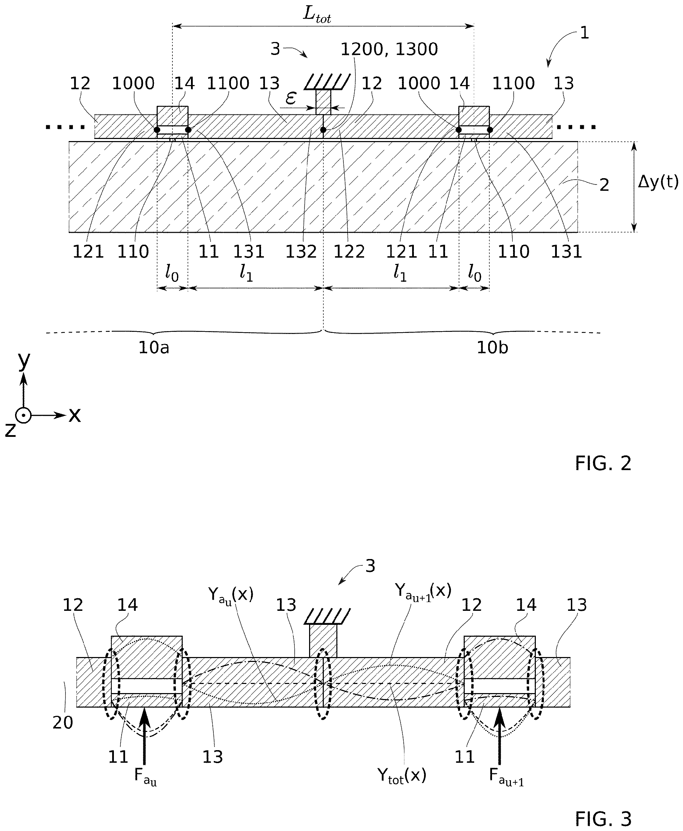

La figure 2 représente deux cellules élémentaires 10a et 10b adjacentes entre elles (ou consécutives), le cas échéant dans ladite structure refermée sur elle-même, qui sont en liaison mécanique avec le résonateur 2 sur son pourtour se déformant suivant l'axe y (Cf. figure 2) lorsque le résonateur est en fonctionnement.

Plus particulièrement, le schéma de la figure 2 illustre des noeuds dits de fonctionnement, notés parfois ci-dessous $n_{u0}$ et $n_{u1}$, dont au moins deux noeuds d'un premier type $n_{u1}$ comprenant par exemple les points référencés 1000 et 1100, et des noeuds d'un second type $n_{u0}$ comprenant par exemple les points référencés 1200 et 1300. Par barreau primaire 11, les deux noeuds de fonctionnement 1000 et 1100 doivent de préférence être respectivement situés dans les zones ovales en tirets gras qui sont illustrées sur la figure 3 au droit des extrémités 111 et 112 de chaque barreau primaire 11 et au droit des extrémités de chaque barreau tertiaire 14, et notamment entre le barreau primaire 11 concerné et le barreau tertiaire 14 concerné. En référence aux figures 2 et 3, chaque noeud de fonctionnement 1200 doit de préférence être situé dans une zone ovale en tirets gras qui est illustrée sur la figure 3 entre le barreau secondaire 12 d'une première des deux cellules élémentaires illustrées et le barreau secondaire 13 de la cellule élémentaire adjacente, et notamment au droit d'une seconde extrémité 122 du premier barreau secondaire 12 de la cellule élémentaire de gauche et au droit du bâti 3. Toujours en référence aux figures 2 et 3, chaque noeud de fonctionnement 1300 doit de préférence être situé dans une zone ovale en tirets gras qui est illustrée sur la figure 3 entre le barreau secondaire 13 d'une première des deux cellules élémentaires illustrées et le barreau secondaire 12 de la cellule élémentaire adjacente, et notamment au droit d'une seconde extrémité 132 du deuxième barreau secondaire 13 de la cellule 10a et au droit du bâti 3. Les noeuds de fonctionnement 1200 et 1300 sont de préférence distants entre eux de moins de 30%, avantageusement de moins de 10%, de la longueur d'onde d'excitation du résonateur 2 près ; ils sont de préférence sensiblement confondus entre eux. Cette préférence est rencontrée dès lors que les barreaux secondaires présentent une même longueur, sont liés deux à deux par une de leurs extrémités, et que les barreaux secondaires sont liés mécaniquement au bâti 3 par les extrémités de la cellule élémentaire à laquelle ils appartiennent.

Il est recherché que ces noeuds de fonctionnement 1000, 1100, 1200 et 1300 correspondent à des zones où l'amplitude de déformation des barreaux $B_{u0}$, $B_{u1}$ et $B_{u2}$ est quasiment nulle pour une fréquence d'excitation déterminée du résonateur 2 prise dans une bande de fréquence déterminée, typiquement prise dans sa bande utile, par exemple entre sa fréquence de résonance et sa fréquence d'antirésonance. Pour cela, les barreaux primaires 11 et secondaires 12 et 13 d'au moins une cellule élémentaire 10a, de préférence de chaque cellule élémentaire 10a, 10b, 10c, ..., peuvent avantageusement être dimensionnés de sorte que, pour un signal d'excitation du résonateur 2 à la fréquence d'excitation déterminée du résonateur 2, les noeuds de fonctionnement 1000, 1100, 1200 et 1300 se retrouvent bien aux endroits dessinés sur la figure 2 ou plus généralement dans une zone respective parmi les zones ovales en tirets gras illustrées sur la figure 3, à 30%, avantageusement à 10%, de la longueur d'onde d'excitation du résonateur 2 près.

Une autre façon d'exprimer cet effet technique recherché consiste à imposer, en ces noeuds de fonctionnement 1000, 1100, 1200 et 1300, un mouvement d'amplitude inférieur à 10% de l'amplitude de déformation maximale générée dans les barreaux secondaires 12 et 13.

Une fois ce premier dimensionnement effectué, ou en alternative, le barreau tertiaire 14 d'au moins une cellule élémentaire 10a, de préférence le barreau tertiaire 14 de chaque cellule élémentaire 10a, 10b, 10c, etc. est de préférence dimensionné afin de favoriser la propagation d'ondes mécaniques en provenance des barreaux secondaires 12 et 13 vers les barreaux tertiaires 14 plutôt que vers les barreaux primaires 11.

Ces effets techniques recherchés, afin de minimiser l'énergie mécanique transmise par le résonateur 2 au bâti 3 via la fixation 1, sont atteints, grâce au dispositif de maintien 1 selon le premier aspect de l'invention, par exploitation de trois principes élémentaires ci-dessous présentés brièvement, avant d'être présentés plus bas de façon plus détaillée.

En référence à la figure 3, le premier principe à exploiter vient de ce que la force $\vec{F}_{au(+1)}$ transmise par le résonateur 2 vibrant au(x) barreau(x) primaire(s) 11 est proportionnelle à l'impédance mécanique $Z$ du(des) barreau(x) primaire(s) 11 que multiplie la vitesse $\vec{v}$ de déplacement des noeuds de fonctionnement 1000 et 1100 du premier type $n_{u1}$, cette vitesse de déplacement étant sensiblement égale à la vitesse de déformation du résonateur piézoélectrique 2 excité, du fait des liaisons mécaniques 110 entre la fixation 1 et le résonateur 2 : $\vec{F} = Z.\vec{v}$.

Comme l'on cherche à limiter au maximum l'énergie transmise par le résonateur 2 au bâti 3 via la fixation 1, il est avantageux que les barreaux primaires 11 soient dimensionné(s) de sorte qu'ils soient mis en résonance avec le résonateur 2 vibrant pour garantir l'existence des noeuds 1000 et 1100 du premier type $n_{u1}$. Pour ce faire, il convient de dimensionner les barreaux primaires 11 de sorte qu'ils présentent une impédance mécanique quasi nulle. On peut alors choisir l'impédance mécanique Z tel que à la fréquence de travail et pour le déplacement maximal généré en périphérie du résonateur, la puissance fournie par le résonateur au support soit inférieure à 30% de la puissance perdue en interne via ses pertes mécaniques. La mise en résonance des éléments 11 permet de minimiser la transmission de l'énergie mécaniques de ces éléments vers les éléments 12 et donc *in fine* l'énergie extraite au résonateur 2 par le dispositif de maintien 1 dans son environnement de travail 3.

En référence aux figures 2 et 3, le deuxième principe à exploiter consiste à faire interférer entre elles les ondes de déformations induites aux niveaux des liaisons mécaniques consécutives, parfois notées ci-dessous $a_u$ et $a_{u+1}$, entre les cellules élémentaires 10a et 10b et le résonateur 2. Ceci contribue avantageusement à confiner les ondes de déformation de sorte que celles-ci restent pour l'essentiel dans la fixation 1 et ne se propagent pas au bâti 3 par les noeuds $n_{u0}$ du second type. Cette fonction est réalisée par les barreaux secondaires 12 et 13, notés parfois ci-dessous $B_{u1}$. En effet, en faisant interférer deux ondes de déformation induites aux niveaux de deux liaisons mécaniques consécutives $a_u$ et $a_{u+1}$, l'on s'assure que les noeuds de fonctionnement 1200 et 1300 soient des noeuds de déplacement nul étendus. Pour ce faire, chacun des premier et second barreaux secondaires 12 et 13 d'au moins une cellule élémentaire 10a, de préférence de chaque cellule élémentaire 10a, 10b, 10c, ..., peut être dimensionné de sorte à présenter une longueur sensiblement égale à un multiple d'une demi-longueur d'onde de la fréquence, éventuellement moyenne, d'excitation du résonateur 2 et/ou de sorte à présenter un moment quadratique, par rapport à leur axe longitudinal, au moins quatre fois supérieur, de préférence au moins dix fois supérieur, à un moment quadratique du barreau primaire 11 par rapport à son axe longitudinal.

Le troisième principe exploite le fait que la propagation d'une onde de déformation en provenance d'un barreau primaire $B_{u0}$ vers un barreau secondaire $B_{u1}$ n'est pas équivalente à celle d'une onde en provenance d'un barreau

secondaire $B_{u1}$ vers un barreau primaire $B_{u0}$. L'exploitation de ce troisième principe vise là encore notamment à minimiser la mise en interférence d'ondes de déformation qui conduirait à une augmentation du transfert d'énergie du résonateur 2 vers le bâti 3 via la fixation 1. Cet objectif est essentiellement atteint par dimensionnement des barreaux tertiaires $B_{u2}$. Plus particulièrement, pour atteindre l'objectif fixé, chaque barreau tertiaire 14 peut :

- présenter une longueur sensiblement égale à la longueur du barreau primaire 11, et/ou
- présenter une épaisseur (ou plus généralement une surface de section transversale) supérieure, de préférence au moins deux fois supérieure, à une épaisseur (ou plus généralement une surface de section transversale) du barreau primaire 11, et/ou
- être adapté en impédance mécanique avec les premier et second barreaux secondaires 12 et 13.

Nous revenons ci-dessous plus en détail sur chacun des trois principes introduits ci-dessus.

Minimisation du transfert d'énergie entre le bâti et le résonateur par les barreaux primaires $B_{u0}$

Au niveau des points de contact 110 entre le dispositif de maintien 1 et le résonateur 2, ces points étant notés ci-dessous $a_u$ et $a_{u+1}$ pour deux cellules élémentaires adjacentes $u$ et $u + 1$, des ondes mécaniques transverses d'amplitude $\Delta Y_0$ sont générées à la pulsation $\omega$ dans le matériau constitutif du dispositif de maintien 1 et donc d'abord dans les barreaux $B_{u0}$ et $B_{(u+1)0}$. Ici, l'ensemble du dispositif de maintien 1 se veut dimensionné pour fonctionner avec un résonateur 2 travaillant sur une plage de fréquence bien définie, entre sa fréquence de résonance et sa fréquence d'antirésonance sur un mode choisi ; l'intervalle comprenant la pulsation $\omega$ de déformation est donc connu.

Dans un premier temps, nous n'allons considérer que l'onde de déformation induite en chacun des points de liaison $a_u$, $a_{u+1}$, etc. est sensiblement identique. En effet, on peut considérer que l'ensemble des points d'applications de la déformation, i.e. des points de liaison $a_u$, $a_{u+1}$, etc., se comportent rigoureusement de la même manière par hypothèse de placement desdits points relativement au résonateur 2, et plus particulièrement relativement à son pourtour. Ainsi, nous pouvons considérer le résonateur 2 comme un générateur de déplacement $\Delta y$ d'amplitude $\Delta Y_0$ en $a_{u(+1)}$, tel que :

$$\Delta y\big(a_{u(+1)}, t\big) = \Delta Y_0 e^{i(\omega t + \Phi)},$$

etc.

Dans l'objectif de générer une onde mécanique principalement transverse dans la fixation 1, le barreau primaire 11, noté $B_{u0}$, jouant le rôle d'une tige de soutien, doit être sensiblement dans une direction tangentielle, à 40° près, de préférence à 20° près, au pourtour local du résonateur 2, sachant que le barreau primaire 11 peut lui-même avoir une courbure. Cette tige de soutien $B_{u0}$ doit avoir un mode principal de résonance proche de la pulsation de déformation $\omega$ par rapport à son excitation en $a_{u(+1)}$, et notamment au regard de la direction de cette excitation ; typiquement, si le résonateur 2 a un mouvement transversal, et par exemple radial, et que le barreau primaire 11 est au moins localement tangentiel au pourtour du résonateur 2, alors le barreau primaire 11 fonctionne essentiellement en mode flexion, et il faut alors considérer le mode principal de résonance en mode flexion. Ensuite, à même fréquence de résonance, typiquement à même valeur du paramètre $\sqrt{\dfrac{k}{m}}$, où m est la masse équivalente ramenée en bout de poutre du barreau primaire 11 et où k est sa raideur, plus ladite masse est faible, plus la raideur est faible, et plus les efforts transmis par cette raideur sont faibles. Ainsi, parmi les solutions géométriques possibles pour le barreau primaire 11, il est avantageux de prendre la plus petite. Ce choix optimal vis-à-vis de la transmission des efforts mécaniques est toutefois limité par :

- Les possibilités de fabrication, par exemple concernant l'épaisseur minimale qui peut être atteinte selon le procédé de fabrication sélectionné et le coût de la précision/finesse associée,
- Les contraintes mécaniques dans le barreau primaire 1, et
- La robustesse du barreau primaire 11, et plus généralement de la fixation 1 (tenue aux chocs par exemple).

Pour minimiser les contraintes mécaniques dans le matériau constitutif du barreau primaire 11, il est avantageux que son amplitude de déplacement soit faible devant l'épaisseur du barreau primaire 11 ; typiquement, on choisira une épaisseur de barreau primaire 11 au moins 10 fois supérieure à l'amplitude de déformation, par exemple moyenne, du résonateur piézoélectrique dans sa bande de fréquence d'excitation.

En considérant chaque barreau primaire 11 comme une poutre excitée sur un mode de flexion, l'énergie transmise au dispositif de maintien 1 sur une période de fonctionnement T au niveau du barreau primaire 11, dépend à la fois de la vitesse du déplacement $\overrightarrow{v(a_{u(+1)})}$ du barreau primaire, qui est imposée par le résonateur 2, et de la force $\overrightarrow{F(a_{u(+1)})}$

que le barreau primaire 11 va générer en opposition à son déplacement :

$$E_{transmis}(a_u(+1)) = \int_T \overrightarrow{F(a_{u(+1)})}.\overrightarrow{v(a_{u(+1)})}dT$$

On comprend alors que minimiser la force d'opposition de chaque barreau primaire 11 à son point de déplacement permet de réduire l'énergie totale fournie au reste du dispositif de maintien 1 par le résonateur 2.

C'est le premier principe mis en jeu dans le cadre du dimensionnement de la fixation 1 selon le premier aspect de l'invention, et qui vise à minimiser l'énergie fournie au reste de la fixation 1 par ses premiers barreaux primaires 11. La raideur opposée par les barreaux primaires 11 sur le résonateur 2 doit donc être faible. Dans le cas de l'emploi de barreaux primaires 11 utilisés en mode flexion, diminuer leur moment quadratique $I_z$ permet de diminuer la force d'opposition et ainsi de minimiser l'énergie transmise à la fixation 1 par le résonateur 2. Aussi, faire entrer en résonance les barreaux primaires 11 à la fréquence d'excitation du résonateur 2 permet de diminuer la raideur équivalente de ces barreaux 11 et donc l'énergie transmise au reste de la fixation 1. Il est donc intéressant de développer des barreaux primaires 11 tels que ceux-ci résonnent à la fréquence de fonctionnement du résonateur 2 et accompagnent son mouvement.

Le dimensionnement des barreaux primaires 11 s'effectue donc de sorte que ceux-ci entrent en résonance pour une fréquence située dans la bande de fréquence de travail du résonateur 2. On cherchera aussi à faire résonner chaque barreau primaire 11 sur un mode premier. De cette manière, on essaye de limiter au maximum la présence d'autres modes de résonance qui pourraient venir s'opposer au déplacement des barreaux primaires 11 dans la plage de travail comprise entre la fréquence de résonance et la fréquence d'antirésonance du résonateur 2.

Par la suite, on cherche à minimiser l'énergie transmise des barreaux primaires 11 vers les barreaux secondaires 12. Sachant que les barreaux primaires 11 sont en résonance ou proche de la résonance (à 20% près, avantageusement à 10% près) à la fréquence de travail du résonateur 2, des quasi-noeuds, c'est-à-dire des points (ou zones) où le déplacement de l'onde transverse développée est très faible, sont générés au niveau des deux noeuds de fonctionnement 1000 et 1100 liés à chaque barreau primaire 11. De fait, à ces endroits, les contraintes générées par les ondes mécaniques de déformation sont maximales pour chaque barreau primaire 11. Or, si les barreaux secondaires 12 et 13 liés mécaniquement à chaque barreau primaire 11 possèdent un moment quadratique plus important, par exemple en raison d'une épaisseur supérieure à celle du barreau primaire 11, le déplacement des barreaux secondaires 12 et 13 produit par le déplacement du barreau primaire 11 de chaque cellule élémentaire est plus faible à iso-contrainte. Ainsi, en raison d'une rupture de raideur linéique entre le barreau primaire 11 et les barreaux secondaires 12 et 13 de chaque cellule élémentaire, l'essentiel de l'énergie fournie par le résonateur 2 reste confinée au niveau du barreau primaire 11 et se propage peu au reste de la fixation. C'est d'ailleurs en réfléchissant l'onde transverse de déformation au niveau des deux noeuds de fonctionnement 1000 et 1100 que le barreau primaire 11 de chaque cellule élémentaire entre en résonance.

Mise en interférence des ondes de déformation pour leur confinement par les barreaux secondaires $B_{u1}$

De par la répartition, de préférence sensiblement symétrique, voire périodique, des cellules élémentaires 10a, 10b, 10c, etc. du dispositif de maintien 1, voire de par la structure périodique qu'il forme, relativement au pourtour du résonateur 2, le dispositif de maintien 1 induit des interférences en son sein entre les ondes de déformations produites au niveau de deux points de liaisons 110 consécutifs $a_u$ et $a_{(u+1)}$ avec le résonateur 2. En effet, les ondes qui entrent au niveau de ces points de liaisons 110 consécutifs $a_u$ et $a_{(u+1)}$ se propagent sur les barreaux primaires 11, $B_{u0}$ et $B_{(u+1)0}$, de deux cellules élémentaires consécutives, sur une distance équivalente, dans le milieu de propagation, à un quart de longueur d'onde d'excitation du résonateur 2, formant des quasi-noeuds au niveau des noeuds de fonctionnement 1000 et 1100 du premier type $n_{u1}$. Puis les ondes se propagent sur les barreaux secondaires 12 et 13 pour finalement se rencontrer aux noeuds de fonctionnement 1200 et 1300 du second type $n_{u0}$ qui sont sensiblement confondus entre eux et situés entre deux cellules élémentaires 10a et 10b consécutives.

En choisissant des barreaux secondaires 12 et 13 présentant une longueur sensiblement égale à un multiple d'une demi-longueur d'onde, alors la rencontre de ces ondes aux noeuds de fonctionnement 1200 et 1300 du second type $n_{u0}$ s'effectue par interférence de nature destructive entre les ondes (voir équations ci-dessous). Finalement, le déphasage induit vient créer un noeud de déplacement nul étendu aux niveaux des noeuds de fonctionnement 1200 et 1300 du second type $n_{u0}$.

Un noeud de déplacement nul étendu est défini ici comme une zone élargie (représentée pour l'exemple, sur la figure 3, par chacune des zones ovales en tirets gras) dans laquelle le déplacement est sensiblement nul, typiquement, sur une distance de $\lambda/10$, où le $\lambda$ est la longueur d'onde éventuellement moyenne de déformation. Le déplacement en un noeud de déplacement nul étendu est de préférence au moins 10 fois inférieur au déplacement maximal au point de déplacement maximal de la fixation 1. Cela permet d'être tolérant sur le point d'ancrage effectif au bâti 3, ainsi que sur la fréquence de travail induite par la vibration du résonateur 2. Ceci est notamment nécessaire dans le cas de l'emploi d'un résonateur piézoélectrique 2 fortement couplé pouvant être amené à fonctionner sur une large plage de fréquence (typiquement 20% de variation de fréquence). Les noeuds de déplacement nul étendus sont obtenus aux points d'interconnexions 1200 et 1300 du second type $n_{u0}$, limitant la transmission d'ondes vers le bâti 3 en ces noeuds 1200 et 1300. De par la structure répétitive, voire périodique, de la fixation 1, l'effet produit aux noeuds de fonctionnement 1200 et 1300 qui sont situés entre les deux cellules élémentaires 10a et 10b consécutives illustrées partiellement sur la figure 2, est aussi obtenu sur les noeuds de fonctionnement 1200 et 1300 qui sont situés entre deux autres cellules élémentaires consécutives entre elles dans la structure que forme la fixation 1. Ces noeuds de fonctionnement 1200 et 1300 du second type $n_{u0}$ peuvent être notés plus bas : $n_{(u-1)0}$, $n_{(u+1)0}$, etc.

Suivant la même réflexion conduite sur la mise en interférence des ondes générées au niveau des points de contacts 110 entre le dispositif de maintien 1 et le résonateur 2, on peut dire que, par construction, chaque barreau secondaire 12 et 13 de chaque cellule élémentaire 10a, 10b, 10c, etc. obtient une raideur relative plus raide sur la fréquence de travail (là où la nature de l'interférence est de type destructive, c'est-à-dire que, pour une certaine contrainte interne, le déplacement relatif sera plus faible que pour le cas de la propagation d'une seule onde notamment sur sa périphérie). Ainsi, le confinement de l'onde lors de sa transmission entre le barreau primaire 11 et les barreaux secondaires 12 et 13 de chaque cellule élémentaire est augmenté.

Finalement, en reprenant l'équation générale de la flèche dans une poutre en flexion développée dans la théorie des poutres d'Euler-Bernoulli, on montre que la structure de la fixation 1 permet d'augmenter la raideur relative des barreaux secondaires et produit des noeuds à déplacement nul étendus aux niveaux des liaisons entre la fixation 1 et le bâti 3.

Plus particulièrement, l'équation générale du déplacement transverse d'une poutre excitée à la pulsation $\omega$ peut s'écrire :

$$y(x,t) = \big(Asin(\beta x) + Bcos(\beta x) + Csinh(\beta x) + Dcosh(\beta x)\big)e^{i(\omega t + \Phi)}$$

$$Y(x) = \big(Asin(\beta x) + Bcos(\beta x) + Csinh(\beta x) + Dcosh(\beta x)\big)$$

en notant $\beta$ le nombre d'onde, $\Phi$ le déphasage, et A, B, C et D des paramètres dépendant des conditions limites imposés à la poutre.

On suppose que, par construction, les ondes de déformations émises aux points de contacts 110 entre le dispositif de maintien 1 et le résonateur 2 sont sensiblement les mêmes. Ainsi, au niveau des noeuds de fonctionnement 1200 et 1300 du second type $n_{u0}$ qui sont situés entre deux cellules élémentaires consécutives entre elles, les deux ondes auront parcouru le même chemin, mais dans deux directions opposées (x croissant ou x décroissant sur la figure 2). En supposant que les matériaux choisis pour les barreaux secondaires sont sensiblement isotropes et que ces barreaux sont sensiblement de même forme et dimensions, éventuellement à une symétrie d'axe ou de plan près, les déformées produites par ces deux ondes sont alors sensiblement équivalentes en amplitude.

En supposant qu'aux noeuds de fonctionnement 1000 et 1100 du premier type $n_{u1}$, un noeud est bien généré par l'onde incidente depuis le point de liaison 110 concerné et que l'énergie transmise aux barreaux secondaires 12 et 13 est faible. On trouve d'une part des conditions d'encastrement au niveau des noeuds $n_{u1}$ et d'autre part une condition de liaison ponctuelle au niveau des noeuds $n_{u0}$, car le dispositif de maintien 1 est relié au bâti sur son pourtour en $n_{u0}$. Ceci nous donne les conditions limites suivantes pour le calcul de la déformée des barreaux 12 et 13 :

$$Y_{a_u}(n_{u1}) \cong 0$$

$$\frac{\partial Y_{a_u}(n_{u1})}{\partial x} \cong 0$$

$$Y_{a_u}(n_{u0}) \cong 0$$

$$M(x(n_{u0}), t) = EI\frac{\partial^2 Y(n_{u0})}{\partial x^2} \cong 0$$

En se plaçant dans un référentiel tel que le noeud 1100 de la cellule élémentaire concernée se situe à $x = 0$, et d'après les hypothèses d'encastrement au niveau du noeud 1100 et de liaisons ponctuelles au niveau des noeuds 1200 et 1300, la solution de la déformée des barreaux secondaires 12 et 13 est la suivante :

$$Y_{au}(x) = Y_0((\cos(\beta x) - \cosh(\beta x)) - 0{,}9825(\sinh(\beta x) - \sin(\beta x)))$$
$$\beta l_1 = 3.927$$

Autour de la liaison mécanique entre la fixation 1 et le bâti 3, donc pour x = $l_1$ + $\varepsilon$ avec $\varepsilon$ petit (Cf. figure 2), et plus particulièrement pour $\varepsilon$ inférieur à 5% de $l_1$, on peut écrire la déformée due à l'onde de déformation produite au niveau de cette liaison de la façon suivante :

$$Y_{au}(l_1 + \epsilon) = Y_0\big((\cos\big(\beta(l_1 + \epsilon)\big) - \cosh(\beta(l_1 + \epsilon)) - 0{,}9825\big(\sinh\big(\beta(l_1 + \epsilon)\big) - \sin\big(\beta(l_1 + \epsilon)\big)\big)\big)$$
$$-0{,}9825(\sinh(\beta l_1)\cosh(\beta\epsilon) + \cosh(\beta l_1)\sinh(\beta\epsilon) - \sin(\beta l_1)\cos(\beta\epsilon) - \cos(\beta l_1)\sin(\beta\epsilon)))$$

$$Y_{a_u}(l_1 + \epsilon) \cong Y_0((\cos(\beta l_1) - \beta\epsilon\sin(\beta l_1) - \cosh(\beta l_1) + \beta\epsilon\sinh(\beta l_1))$$
$$-0{,}9825(\sinh(\beta l_1) + \beta\epsilon\cosh(\beta l_1) - \sin(\beta l_1) - \beta\epsilon\cos(\beta l_1))) + O(\epsilon)$$

$$Y_{a_u}(l_1 + \epsilon) \cong Y_0\big((\beta\epsilon\sinh(\beta l_1) - \beta\epsilon\sin(\beta l_1)) - 0{,}9825(\beta\epsilon\cosh(\beta l_1) - \beta\epsilon\cos(\beta l_1))\big)$$

Pour l'onde se propageant dans le sens opposé, i.e. du point de liaison $a_{u+1}$ de la cellule élémentaire adjacente vers les noeuds de fonctionnement 1200 et 1300 du second type $n_{u0}$, on trouve x = $l_1$ - $\varepsilon$ autour de la liaison mécanique avec le bâti 3. Il est alors possible d'écrire la formule correspondante et de calculer la superposition des deux ondes de déformation en provenance des points de liaisons $a_u$ et $a_{u+1}$ des deux cellules élémentaires concernées autour de leur point de rencontre $n_{u0}$ :

$$Y_{tot}(n_{u0}) = Y_{a_u}(l_1 + \epsilon) + Y_{a_u}(l_1 - \epsilon)$$

$$Y_{tot} = 0 + O(\epsilon)$$

On peut donc dire que, autour de chacun des noeuds de fonctionnement 1200 et 1300 du second type $n_{u0}$, des noeuds de déplacements nuls étendus sont induits en raison de la répétition, éventuellement périodique, des cellules élémentaires 10a, 10b, 10c, etc. Comme la vibration autour des noeuds de fonctionnement 1200 et 1300 est dès lors très faible, elle ne se propage quasiment pas au reste du bâti 3 et reste confinée dans la fixation 1.

Ensuite, en référence à la figure 2, on peut considérer que l'onde émise au point de liaison 110, (noté $a_{u+1}$), consécutif à un premier point de liaison 110, noté $a_u$, va continuer à interférer avec l'onde émise au premier point de liaison 110 (noté $a_u$) dans le barreau secondaire 13 de la cellule élémentaire 10a et, inversement, l'onde émise au premier point de liaison 110, noté $a_u$, va interférer avec l'onde émise depuis le deuxième point de liaison $a_{u+1}$ dans le barreau secondaire 12 de la deuxième cellule élémentaire 10b.

Comme précédemment, l'interférence est de nature destructive ce qui a tendance à limiter l'amplitude de déplacement des barreaux secondaires 12 et 13 et donc contribue à minimiser des pertes qui sont fonctions de la quantité de matière déplacée.

Ce phénomène est illustré au travers de la figure 3. On peut y observer :

- en tirets long-courts, une première onde de déformation générée par le point de fixation $a_u$, et
- en pointillés, une seconde onde de déformation générée par le point de fixation $a_{u+1}$.

La superposition des deux ondes, dans le cas simplifié d'un milieu sans dissipation avec des barreaux dimensionnés de la façon explicitée précédemment, est représentée en tirets. On remarque alors que, dans l'ensemble des barreaux secondaires 12 et 13, les ondes de déformations interfèrent et s'annulent. Cependant, la contrainte en leur sein, notamment sur leurs extrémités, reste significative. On peut donc dire que la raideur relative des barreaux secondaires 12 et 13 est augmentée, ce qui limite la propagation des ondes de déformation générées aux points de fixation $a_u$ et $a_{u+1}$ vers les barreaux secondaires 12 et 13 situés entre les points de fixation $a_u$ et $a_{u+1}$.

Milieu de propagation anisotrope pour les ondes transverses entre les barreaux primaires $B_{u0}$ et secondaires $B_{u1}$ par les barreaux tertiaires $B_{u2}$

Au travers du schéma de la figure 3, on comprend l'intérêt des barreaux tertiaires 14 qui créent des chemins de propagation favorable pour les ondes de déformation en provenance des liaisons mécanique de la fixation 1 au bâti 3 vers les noeuds de fonctionnement 1000 et 1100 du premier type $n_{u1}$ (Cf. les ondes représentées dans les barreaux 14 illustrés sur la figure 3). La présence de tels chemins est hautement préférable car, au vu des déphasages imposés par la fixation 1 proposée, les ondes de déformation au niveau des points de liaison $a_u$ et $a_{u+1}$ se retrouveraient en interférence destructive avec les ondes arrivant/revenant des barreaux primaires 11, ceci ayant pour conséquence d'augmenter la raideur relative des barreaux primaires 11 et donc d'augmenter le transfert d'énergie entre la fixation 1 et le résonateur piézoélectrique 2. Pour cette raison, il est proposé de créer un chemin de propagation plus favorable (c'est-à-dire possédant une raideur linéique équivalente), tel que l'onde de déformation se propage principalement dans ce chemin. Pour maximiser le transfert de l'onde de déformation entre les barreaux secondaires 12 et 13 et tertiaire 14, il est donc préférable que ceux-ci soient adaptés en impédance. Cependant, comme par interférence destructive les barreaux secondaires 12 et 13 sont rendus très raides à la fréquence de travail (Cf. supra), on cherchera à produire des barreaux tertiaires 14 tels leur moment quadratique par rapport à l'axe de travail soit bien plus grand que dans les barreaux primaires 11.

En faisant ainsi, les ondes générées par les points de fixation $a_u$ et $a_{u+1}$ considérés ne viendront pas modifier la raideur équivalente des barreaux primaires 11, ce qui n'entraînera donc pas de modification sur le transfert de puissance du résonateur 2 vers le bâti 3 (transfert qui doit rester minime).

Point sur le dimensionnement

Il est préférable qu'une attention soit portée sur la distance entre les points de liaison $a_u$ et $a_{u+1}$ entre la fixation 1 et le résonateur 2. En effet, si les points de liaison $a_u$ et $a_{u+1}$ sont situés à des distances telles que la distance total $L_{tot}$ entre deux points de liaisons soit égale ou multiple d'une demi-longueur d'onde pouvant être générée sur la périphérie du résonateur 2 dans la bande de fréquence de travail, une résonance favorisée peut apparaître sur les contours de celui-ci. Par exemple, dans le cas de résonateurs de type disque, si trois points de contacts sont employés alors que celui-ci fonctionne sur un mode radial, alors la distance des points deux à deux est de $L_{tot} = \dfrac{2\pi}{3} R$ avec $R$ le rayon du résonateur 2. Or $2R$ correspond à la longueur caractéristique principal de travail. Comme $L_{tot}$ est proche de cette longueur, on peut supposer qu'un mode de contour favorable puisse être excité ce qui n'est pas désiré. On préférera donc travailler avec quatre cellules élémentaires et donc quatre points de fixation du résonateur 2 sur la fixation 1.

L'invention proposée repose donc sur trois principes distincts qui sont :

- minimiser l'énergie transmise à la fixation 1 par le résonateur 2 en utilisant une barreau primaire peu raide à la fréquence de travail,
- développer des noeuds de connexion à déplacement sensiblement nul étendus au niveau des jonctions mécaniques entre cellules consécutives qui permettent d'interfacer la fixation 1 avec le bâti 3 et ainsi d'isoler le résonateur 2 de son environnement de travail 3, et
- créer des chemins de propagation favorable via le barreau tertiaire 14 tel que l'onde mécanique de déformation générée par un ancrage avoisinant ne puisse interférer avec le barreau primaire 11.

Comme on a pu le voir ci-dessus, pour minimiser l'énergie transmise du résonateur 2 à la fixation 1, les barreaux primaires 11 sont dimensionnés pour résonner à une fréquence dans la plage de fréquence de travail du résonateur. Les barreaux primaires 11 sont comme encastrés-encastrés sensiblement au niveau des noeuds de fonctionnement 1000 et 1100 du premier type $n_{u1}$, et chaque point de fixation $a_u$ du résonateur 2 à la fixation 1 est sensiblement situé au milieu du barreau primaire 11 qui le porte. La fréquence de résonance de ces barreaux primaires 11 est choisie de sorte qu'elle corresponde à leur mode principal de résonance en considérant chaque barreau primaire 11 en lui-même, i.e. non lié mécaniquement au résonateur 2. Pour plus de précisions dans le dimensionnement des barreaux primaires 11, on peut inclure l'éventuel plot ou ergot de connexion 110, à minima la masse de ce plot, pour que l'ensemble « barreau primaire 11 + plot de connexion » résonne bien à la fréquence souhaitée. Par ailleurs, en plus du respect de la fréquence de résonance, chaque barreau primaire 11 est choisi pour être le plus souple possible dans la limite des possibles techniques et économique, afin de limiter encore plus l'énergie transmise à la fixation 1.

Par ailleurs, en créant une rupture d'impédance mécanique de transmission aux niveaux des noeuds de fonctionnement 1000 et 1100 du premier type $n_{u1}$, peu d'énergie se retrouve transmise au reste de la fixation 1, i.e. à l'ensemble formé des barreaux primaire 11 et tertiaire 14.

Ensuite, en réalisant le dispositif de maintien 1 de manière symétrique, voire périodique, autour du résonateur 2, les ondes de déformation produites dans la fixation 1 sont mises en interférence destructive ce qui permet à la fois d'augmenter la raideur équivalente des barreaux secondaires 12 et 13, mais aussi de créer des noeuds de connexions à déplacements nuls étendus aux niveaux des liaisons mécaniques entre cellules élémentaires consécutives. Ce sont ces noeuds de fonctionnement 1200 et 1300 du second type $n_{u0}$ qui sont employés avantageusement pour interfacer mécaniquement la fixation 1 avec le bâti 3.

Enfin, afin que les ondes de déformation circulant dans les barreaux secondaires 12 et 13 ne viennent pas perturber et augmenter la raideur équivalente des barreaux primaires 11, ce qui augmenterait l'énergie fournie à la fixation 1 par le résonateur 2, la propagation des ondes de déformation entre les barreaux primaires 11 et les barreaux secondaires 12 et 13 est minimisée via l'emploi des barreaux tertiaires 14 en tant que guides d'ondes qui représentent des chemins de transfert d'énergie plus favorables. En effet, l'épaisseur des barreaux tertiaires 14 peut être choisie grande devant l'épaisseur des barreaux primaires 11. Idéalement, chaque barreau tertiaire 14 est adapté en impédance mécanique avec les barreaux secondaires 12 et 13 de sorte que l'essentiel de l'énergie en provenance des barreaux secondaires soit absorbé par les barreaux tertiaires 14 et non par les barreaux primaires 11. Dans les faits, comme la raideur des barreaux secondaires 12 et 13 est augmentée à la fréquence de fonctionnement par mise en interférence destructive, on cherchera à rendre les barreaux tertiaires 14 plus raides que les barreaux primaires 11. Quant aux barreaux primaires 11, pour minimiser leur raideur, ils sont de préférence choisis fins devant l'épaisseur des barreaux secondaires 12 et 13, ce qui accentue la rupture d'impédance mécanique et limite les échanges d'énergie entre barreaux primaire 11 et secondaires 12 et13, ce qui est aussi avantageux.

L'invention proposée adresse la problématique principale de tenir/maintenir mécaniquement un résonateur piézoélectrique 2 tout en limitant l'impact de son dispositif de maintien 1 pour des modes de travail de type résonance longitudinale et/ou transversale. Contrairement aux solutions évoquées en introduction, le dispositif de maintien 1 selon le premier aspect de l'invention utilise la mise en interférence des ondes se propageant en son sein pour minimiser l'énergie transférée du résonateur vers le bâti 3 et pour créer des noeuds étendus facilitant la connexion du dispositif de maintien 1 au bâti 3, tout en limitant le transfert d'énergie au bâti 3. Se faisant, les dimensions du dispositif de maintien 1 peuvent être considérablement réduites. Le principe même du dispositif de maintien 1 décrit ci-dessus peut être adapté à plusieurs géométries (dimensions et forme) de résonateurs 2 et peut être réalisé dans plusieurs matériaux différents.

La partie qui suit présente, à titre d'exemple, des règles de calculs pour le dimensionnement d'un dispositif de maintien 1 adapté à un résonateur 2 prenant la forme d'un disque.

Cas d'un résonateur de type disque fonctionnant sur un mode principal de type radial

Un dispositif de fixation 1 conforme au premier aspect de l'invention est donné ci-dessous, pour l'exemple, qui permet de maintenir un résonateur piézoélectrique 2 de forme circulaire fonctionnant sur un mode vibratoire de type radial. Afin de maintenir le résonateur 2 de manière à minima isostatique, un minimum de trois points d'attache 110 sont nécessaires. Cependant, comme vu précédemment, la distance entre les points d'attache 110 sur la périphérie du résonateur 2 est alors de $\frac{\pi}{3} 2R$, et, comme $\frac{\pi}{3}$ est proche de 1, on peut facilement supposer qu'un mode diamétral viendra interférer dans notre bande de fonctionnement entre la fréquence de résonance et la fréquence d'antirésonance du résonateur 2. Une solution consiste en l'ajout d'un quatrième point d'attache 110 qui réduit la distance entre les points d'attache et permet d'isoler le mode de résonance diamétrale à une fréquence supérieure loin de la bande d'utilisation. Avec quatre points d'attache, le dispositif de maintien 1 peut être tel qu'illustré sur la figure 4.

Les premiers paramètres importants à considérer sont la bande fréquentielle de travail de la fixation 1 développée et aussi la dimension $L_{tot}$ disponible pour la réalisation d'une cellule (ou motif) élémentaire du dispositif de maintien 1. Ces deux paramètres sont directement liés au choix du matériau piézoélectrique résonant et aux dimensions de celui-ci.

Dans le présent exemple, nous dimensionnons ci-dessous le dispositif de maintien 1 pour un résonateur circulaire de 25mm de diamètre constitué d'un matériau piézoélectrique à base de PZT (pour titano-zirconates de plomb) connu sous l'appellation commerciale C213 de Fujiceramic®. Ce résonateur possède alors une fréquence de résonance de 89kHz et d'antirésonance de 103kHz. C'est donc à cette gamme de fréquence que les barreaux 11, 12, 13 et 14 de chaque cellule élémentaire 10a, 10b, 10c et 10d du dispositif de maintien 1 devront être adaptés. De plus, comme nous avons opté pour quatre points de maintien, on sait que pour un dispositif de maintien 1 situé à une distance moyenne de 1,5 mm du pourtour extérieur circulaire du résonateur, on a $L_{tot} \cong 22$mm.

Peut venir ensuite le choix du matériau constitutif du dispositif de maintien 1. Un matériau couramment utilisé en électronique est le FR-4 TG150. Son intérêt est qu'il possède de bonnes propriétés diélectriques et peut être acheté en plaques recouvertes de cuivre. Ceci permet d'obtenir deux plans parallèles conducteurs isolés électriquement l'un de l'autre qui sont intéressant pour la reprise des contacts électriques entre le résonateur piézoélectrique 2 et le bâti 3 à travers la fixation 1.

Le FR-4 TG150 possède un module d'Young E de 22GPa et une densité $\rho$ de 1900kg/m$^3$. Dans une démarche de simplification du procédé, il est choisi d'employer des plaques de FR-4 standard qui possèdent une hauteur de 1,55mm et qui sont recouvertes d'une couche de cuivre de 70$\mu$m d'épaisseur. Comme l'épaisseur du cuivre est faible devant la hauteur du FR-4, on considérera uniquement le FR-4 pour le dimensionnement mécanique. De plus, bien que ce soit un matériau composite, on le considérera comme isotrope pour le dimensionnement des barreaux $B_{u0}$, $B_{u1}$ et $B_{u2}$. De plus, on ne considérera pour l'exemple que des barreaux de section rectangulaire, plus simples à réaliser lors de l'usinage d'une plaque de FR-4 avec une fraise ou un laser.

EP 4 576 573 A1

Dimensionnement des barreaux primaires B_u0

Le premier ensemble de barreaux à dimensionner correspond à l'ensemble des barreaux primaires, référencés 11 et notés $B_{u0}$. En effet, leur longueur et leur épaisseur dimensionneront l'ensemble du reste du dispositif de maintien 1. Ainsi, supposons que, pour des raisons de fabrication, l'épaisseur (suivant y dans le schéma de la figure 1) des barreaux primaires $B_{u0}$ est de $e_0 = 0,5$mm. Il faut alors calculer leur longueur de sorte qu'ils puissent rentrer en résonance à une fréquence comprise dans la bande de fonctionnement/travail choisi du résonateur 2. Les méthodes permettant de déterminer la déformée de poutres en dynamique sont formulées au travers de la théorie des poutres d'Euler-Bernoulli, l'équation fondamentale d'une poutre en flexion suivant l'axe y est alors la suivante :

$$\frac{EI_z}{\rho S}\frac{\partial^4 y(x,t)}{\partial x^4} + \frac{\partial^2 y(x,t)}{\partial t^2} = f(x,t)$$

Avec $I_z$ le moment quadratique de flexion associé, S la section de la poutre, $y$ le déplacement et $f$ la densité de force extérieure. Dans notre cas, comme on applique une force de manière ponctuelle, on considérera la densité de force extérieure nulle. De plus, on sait par avance que l'on va chercher à faire résonner notre poutre, et plus particulièrement notre barreau primaire 11, sur son mode premier et sachant que celle-ci sera liée en son centre au résonateur 2. Comme chaque cellule élémentaire 10a, 10b, 10c et 10d est parfaitement symétrique, les conditions aux limites sont les mêmes. Les solutions à l'équation ci-dessus sont alors de la forme :

$$y(x,t) = \big(A sin(\beta x) + B cos(\beta x) + C sinh(\beta x) + D cosh(\beta x)\big)e^{i\omega t + \phi}$$

$$\beta = \sqrt{\omega} * \sqrt[4]{\frac{\rho S}{EI_z}}$$

Par hypothèse de construction, le barreau primaire, référencé 11 noté $B_{u0}$, est considéré comme encastré sur ses deux extrémités. Ainsi, aux limites du barreau primaire 11, on peut considérer des déplacements transversaux et angulaires quasiment nuls. On a donc :

$$y(x(n_{u1}),t) \cong 0$$

$$\theta(x(n_{u0}),t) = \frac{\partial y(x,t)}{\partial x}\bigg|_{x=x(n_{u1})} \cong 0$$

Sachant les conditions aux limites, et la forme de la solution précédemment introduite, on trouve que les pulsations propres de chaque barreau primaire 11 sont les solutions de l'équation :

$$\tan \beta l_0 + \tanh \beta l_0 = 0$$

La solution du premier mode de vibration qui correspond au mode que l'on cherche à implémenter est alors donnée par les équations suivantes :

$$\beta * l_0 = 4.73$$

$$l_0 = \frac{4.73}{\sqrt{\omega}} \sqrt[4]{\frac{EI_z(B_{u0})}{\rho S_0}}$$

Connaissant l'épaisseur (0,5mm) et la hauteur des barreaux (1,55mm), leur module de flexion et leur section peuvent être calculés tel que :

$$I_z(B_{u0}) = \frac{he_0^3}{12}$$

$$S_0 = he_0$$

En employant la formule décrite ci-dessus et en considérant une fréquence de résonance du barreau de 95kHz (soit une pulsation comprise dans la bande de fréquence de travail). On trouve une longueur $l_0$ des barreaux primaires $B_{u0}$ égale à 4,3mm.

Dimensionnement des barreaux secondaires $B_{u1}$

L'architecture du dispositif de maintien étant périodique, on cherche à faire reboucler la cellule élémentaire. Ainsi, dans le cas où l'on considère que le dispositif de maintien 1 est situé à une distance d'environ 1,5 mm par rapport au rayon du résonateur 2 et que celui est répété 4 fois, on trouve alors que la longueur moyenne disponible est donnée par :

$$L_{tot} = (R_{PR} + 1.5e - 3) * 2 * \frac{\pi}{4}$$ , où $R_{PR}$ est le rayon du résonateur 2.

Dans notre exemple, on trouve ici $L_{tot}$ qui est égale à 22mm. Considérant qu'une portion de 4,3mm est déjà utilisée par le barreau primaire de chaque cellule élémentaire, on sait que les deux barreaux secondaires 12 et 13 de chaque cellule élémentaire totalisent une longueur de 17,7mm. Ainsi, la longueur $l_1$ d'un seul barreau secondaire $B_{u1}$ est de 8,85mm. De cette manière, le dispositif de maintien 1 reboucle sur lui-même autour du résonateur 2.

Les barreaux secondaires 12 et 13 sont liés sur leur pourtour au bâti 3 aux niveaux des noeuds de fonctionnement 1200 et 1300. On considère la liaison entre les barreaux secondaires 12 et 13 et le bâti 3 comme ponctuelle. De plus, les barreaux sont maintenus sur leur second côté via un barreau considérée comme très rigide sensiblement au niveau d'un noeud de déplacement nul 1000 ou 1100. Ainsi les barreaux $B_{u1}$ sont considérés comme encastrés d'une part et liés ponctuellement d'autre part. En réutilisant les équations développées ci-dessus et l'équation du module de flexion, l'épaisseur des barreaux $B_{u1}$ peut être calculée telle qu'elle corresponde à une demi-longueur d'onde à une fréquence prise dans la bande de fonctionnement du résonateur 2, et de préférence prise sensiblement en son centre ou son centre géométrique :

$$e_1 = \frac{\sqrt{\frac{12\rho}{E}}(L_{tot} - l_0)^2}{4.73^2} \, \omega$$

Ainsi dans notre cas d'exemple, on trouve que les barreaux secondaires $B_{u1}$ possèdent une épaisseur de 3,4 mm pour un rayon de courbure moyen de 14,5 mm par rapport au centre du résonateur 2. Avec ces dimensions, des noeuds de déplacement nul étendus sont créés aux points $n_{u0}$ de fixation du dispositif de maintien 1 au bâti 3.

Dimensionnement des barreaux tertiaires $B_{u2}$

Pour ce qui est du dernier type de barreaux des cellules élémentaires du dispositif de maintien 1, i.e. les barreaux tertiaires 14, notés $B_{u2}$, on cherche à le rendre adapté en impédance vis-à-vis des barreaux secondaires $B_{u1}$, de sorte que, les ondes de déformation se propageant des barreaux secondaires $B_{u1}$ vers les barreaux tertiaires $B_{u2}$ et primaires $B_{u0}$ se propagent majoritairement dans les barreaux tertiaires $B_{u2}$ et peu dans les barreaux primaires $B_{u0}$. Cependant, dans les barreaux secondaires $B_{u1}$, les ondes de déformations sont mises en interférence destructive ce qui rend ces barreaux très rigides à la fréquence d'étude. Finalement, afin d'être adapté en impédance, il faudrait que les barreaux tertiaires $B_{u2}$ soient aussi rigides ce qui entraînerait des barreaux très épais. On cherchera donc juste à trouver une épaisseur de ces barreaux tertiaires $B_{u2}$ telle que leur moment quadratique soit bien plus grand que le moment quadratique des barreaux primaires $B_{u0}$. On peut par exemple considérer un facteur 10 (au moins 4 et avantageusement plus de 10). On cherche donc :

$$I_Z(B_{u2}) = 10 I_z(B_{u0})$$

$$e_2 = \sqrt[3]{10} e_0$$

On trouve alors que l'ensemble des barreaux tertiaires $B_{u2}$ posséderont une épaisseur de 1,07mm suivant ce critère. Bien entendu, le rapport 10 n'est pas fixe et d'autres facteurs peuvent être employés notamment si l'on cherche à réduire la surface utilisée par le dispositif de maintien 1 ou encore à rendre le dispositif de maintien 1 encore plus performant en rendant les barreaux tertiaires $B_{u2}$ encore plus rigides.

La Figure 4 représente le support dimensionné au moyen des critères ci-dessus. En utilisant les couches de cuivres présentes sur le FR-4, des pistes de connexions électriques reliant l'électrode supérieur du résonateur avec le bâti peuvent être réalisées de manière simple au moyen des procédés classiques de fabrication de cartes à circuits imprimés souvent dénommées PCBs (pour Printed Circuit Boards en anglais). De la même manière, des pistes reliant l'électrode inférieur du résonateur avec le bâti peuvent aussi être fabriquées.

Le bâti peut être une continuité du matériau utilisé pour la fixation, par exemple, dans le cas de l'utilisation d'un PCB comme décrit dans cette exemple, le PCB peut se poursuivre pour accueillir l'électronique de pilotage du résonateur et autres fonctions électroniques.

Au travers de l'exemple donné ci-dessus, nous avons donné le dimensionnement d'un dispositif de maintien 1 pour un résonateur 2 de type circulaire. La démarche est applicable pour d'autres formes de résonateurs 2, mais aussi avec d'autres formes de barreaux 11, 12, 13 et 14, on peut envisager des barreaux de section circulaire, de type IPN ou constitués de matériaux différents.

Une alternative à l'exemple donné ci-dessus consiste à ne pas travailler avec un résonateur 2 circulaire mais avec un résonateur possédant une forme quelconque. En utilisant correctement la démarche présentée ci-dessus, il est alors possible, pour une personne du métier, de bien dimensionner les trois types de barreaux élémentaires constitutifs du dispositif de maintien 1 selon le premier aspect de l'invention, de sorte que celui-ci maintienne le résonateur 2 en produisant peu de pertes et en transmettant peu d'énergie au bâti 3. Ces trois types de barreaux élémentaires ne sont pas nécessairement de sections carrés, mais peuvent présenter d'autres formes de sections : IPN, rond, trapézoïdale... De plus, les trois types de barreaux $B_{u0}$, $B_{u1}$ et $B_{u2}$ peuvent être fabriqués dans des matériaux différents.

Une autre alternative consiste à ne pas placer le dispositif de maintien 1 sur la bordure extérieure du résonateur 2, mais de part et d'autre de celui-ci, sur ces faces planes. Ce faisant, il est possible d'utiliser des matériaux qui sont directement des conducteurs électriques (par exemple du laiton) et qui possèdent de meilleures propriétés mécaniques. La seule contrainte pour le placement des points de liaison $a_u$ entre le dispositif de maintien 1 et le résonateur 2 est que, en ces points, le dispositif de maintien 1 subit des déformations transverses sensiblement en phase (à 30° près) et sensiblement de même amplitude (à 20% près).

On peut aussi placer le dispositif de fixation 1 sur la partie interne d'un résonateur 2 prenant la forme d'un disque creux ou anneau, et pas nécessairement suivant le périmètre extérieur de celui-ci, comme c'est le cas dans l'exemple donné ci-dessus. De même, le résonateur 2 peut avoir la forme d'une rondelle/d'un tube et cette rondelle/tube peut être maintenue mécaniquement par un dispositif de maintien 1 selon le premier aspect de l'invention par son périmètre intérieur.

Par ailleurs, dans le cas de l'emploi d'un résonateur piézoélectrique 2 pour de la conversion d'énergie, il est possible de réaliser le dispositif de fixation 1 directement dans le matériau servant de support au circuit électronique (céramique, PCB).

Il est aussi possible de réaliser la fixation 1 dans le même matériau que le résonateur 2, et notamment en continuité avec lui.

Une autre alternative consiste à utiliser le dispositif de maintien 1 sous forme matricielle pour une multitude de résonateurs 2. Ainsi, l'interférence des ondes acoustiques n'est plus nécessairement produite que par les points de liaison mécanique d'un unique résonateur, mais également par les points de liaison mécanique d'autres résonateurs 2, ayant par exemple sensiblement les mêmes caractéristiques. L'intérêt de travailler sous format matriciel est de pouvoir travailler en haute fréquence, celle-ci étant définie par la dimension du résonateur 25 tout en utilisant une grande surface de résonateurs 2, ce qui permet d'augmenter la puissance d'un convertisseur comprenant le dispositif de maintien 1 sous forme matricielle. La figure 5 présente un schéma d'implémentation d'une telle structure matricielle.

Le dispositif de maintien 1 a d'abord été pensé pour l'électronique de puissance et l'emploi de résonateurs piézoélectriques 2 massifs. Il forme un ensemble intéressant avec le composant résonateur piézoélectrique 2 et permet de massifier son usage. Comme dit en introduction, les convertisseurs de puissance sont omniprésents et leur montée en fréquence pose des problèmes. Si la solution d'emploi de résonateurs piézoélectriques 2 s'avère réellement pertinente, le dispositif de maintien selon le premier aspect de l'invention lève le verrou du « comment implémenter ces composants vibrants » sans perturber leur vibration et sans transmettre des vibrations au bâti 3.

A noter également qu'il est tout à fait possible d'utiliser le dispositif de maintien 1 selon le premier aspect de l'invention sur des systèmes radiofréquences, plutôt que sur des convertisseurs de puissance. Ceci permettrait aussi de réduire leur empreinte surfacique.

L'invention n'est pas limitée aux modes de réalisations précédemment décrits et s'étend à tous les modes de réalisation couverts par l'invention.

**Revendications**

1. Dispositif de maintien (1) pour résonateur piézoélectrique (2), le dispositif de maintien (1) comprenant au moins deux cellules élémentaires (10a, 10b et 10c) destinées à être liées mécaniquement entre elles et à être réparties sur un pourtour du résonateur piézoélectrique (2), au moins une, de préférence chaque, cellule élémentaire (10a, 10b, 10c) comprenant quatre barreaux (11, 12, 13 et 14) dont :

   • un barreau dit primaire (11) par lequel le dispositif de maintien (1) est destiné à être lié mécaniquement au résonateur piézoélectrique (2),
   • deux barreaux dits secondaires (12 et 13), dont :

      ◦ un premier barreau secondaire (12) :

         - lié mécaniquement au barreau primaire (11) de la cellule élémentaire (10a) considérée,
         - lié mécaniquement à une cellule élémentaire (10b ou 10c) adjacente à la cellule élémentaire (10a) considérée, et
         - destiné à être lié mécaniquement à un bâti extérieur (3), et

      ◦ un second barreau secondaire (13) :

         - lié mécaniquement au barreau primaire (11) de la cellule élémentaire (10a) considérée,
         - lié mécaniquement à une cellule élémentaire (10b ou 10c) adjacente à la cellule élémentaire (10a) considérée, et
         - destiné à être lié mécaniquement au bâti extérieur (3), et

   • un barreau dit tertiaire (14) liant mécaniquement entre eux le premier barreau secondaire (12) et le second barreau secondaire (13) de la cellule élémentaire (10a) considérée.

2. Dispositif de maintien selon la revendication précédente, dans lequel au moins un, de préférence chaque, barreau primaire (11) d'au moins une, de préférence de chaque, cellule élémentaire (10a, 10b, 10c) est de dimensions telles que, avec un résonateur piézoélectrique (2) configuré pour vibrer dans une bande de fréquence déterminée, le barreau primaire (11) est en résonance, à 20% près, avantageusement à 10% près, avec les vibrations du résonateur piézoélectrique (2) pour une fréquence d'excitation quelconque située dans ladite bande de fréquence déterminée.

3. Dispositif de maintien selon l'une quelconque des revendications précédentes, dans lequel au moins l'un, de préférence chacun, parmi les premier et second barreaux secondaires (12 et 13) d'au moins une, de préférence de chaque, cellule élémentaire (10a, 10b, 10c) est de dimensions telles qu'il présente une longueur sensiblement égale à un multiple d'une demi-longueur d'onde pour une fréquence d'excitation choisie située dans la bande de fréquence déterminée, et de préférence en son centre ou en son centre géométrique, et présentent, par rapport à leur axe longitudinal, un moment quadratique au moins quatre fois supérieur, de préférence au moins dix fois supérieur, à un moment quadratique du barreau primaire (11) par rapport à son axe longitudinal.

4. Dispositif de maintien selon l'une quelconque des revendications précédentes, dans lequel le barreau tertiaire (14) d'au moins une, de préférence de chaque, cellule élémentaire (10a, 10b, 10c), est de dimensions telles qu'il présente une longueur sensiblement égale à la longueur du barreau primaire (11) de la cellule élémentaire considérée, une épaisseur supérieure, de préférence au moins deux fois supérieure, à une épaisseur du barreau primaire (11) de la cellule élémentaire considérée, et est adapté en impédance mécanique avec les premier et second barreaux secondaires (12 et 13) de la cellule élémentaire considérée.

5. Dispositif de maintien selon l'une quelconque des revendications précédentes, dans lequel lesdites au moins deux cellules élémentaires (10a, 10b et 10c) sont destinées à être réparties sur le pourtour du résonateur piézoélectrique (2) en formant une structure refermée sur elle-même, la cellule élémentaire (10b ou 10c) qui est liée mécaniquement au premier barreau secondaire (12) de la cellule élémentaire (10a) considérée, est adjacente, dans ladite structure refermée, à la cellule élémentaire (10a) considérée, et la cellule élémentaire (10b ou 10c) qui est liée mécaniquement au second barreau secondaire (13) de la cellule élémentaire (10a) considérée, est adjacente, dans ladite structure refermée, à la cellule élémentaire (10a) considérée, les cellules élémentaires liées mécaniquement à la cellule élémentaire (10a) considérée pouvant être différentes entre elles.

6. Dispositif de maintien selon l'une quelconque des revendications 1 à 5, dans lequel au moins un barreau, de préférence chaque barreau, parmi les quatre barreaux (11, 12, 13 et 14) est constitué à base d'au moins un matériau, de préférence isotrope, choisi parmi :

   • un métal, tel que le laiton ou le cuivre,
   • du plastique,
   • une céramique,
   • un cristal et
   • un composite de résine époxy renforcé de fibres de verre, tel que du FR-4.

7. Dispositif de maintien selon les revendications 1 à 5, dans lequel au moins un barreau, de préférence chaque barreau, parmi les quatre barreaux (11, 12, 13 et 14) comprend un matériau isolant et une ou plusieurs fines couches métalliques séparées par le matériau isolant, par exemple une plaque pour circuit imprimé.

8. Dispositif de maintien selon les revendications 1 à 5, dans lequel au moins un barreau, de préférence chaque barreau, est constitué à base du même matériau piézoélectrique, de préférence isotrope transverse, que celui dans lequel est destiné à être constitué le résonateur piézoélectrique (2).

9. Dispositif de maintien selon l'une quelconque des revendications précédentes, dans lequel le barreau primaire (11) est destiné à être lié mécaniquement au résonateur piézoélectrique (2) en un premier point de liaison (110) situé sensiblement entre une première extrémité (111) et une seconde extrémité (112) du barreau primaire (112).

10. Dispositif de maintien selon l'une quelconque des revendications précédentes, dans lequel le barreau primaire (11) est destiné à être lié mécaniquement au résonateur piézoélectrique (2) par l'intermédiaire d'un ergot (110), la masse de l'ergot (110) étant le cas échéant pris en compte pour le dimensionnement du barreau primaire (11).

11. Dispositif de maintien selon l'une quelconque des revendications précédentes, dans lequel :

   • le premier barreau secondaire (12) de la cellule élémentaire (10a) considérée est lié mécaniquement par une première (121) de ses deux extrémités (121 et 122) à la première extrémité (111) du barreau primaire (11) de la cellule élémentaire (10a) considérée, est lié mécaniquement par une seconde (122) de ses deux extrémités (121 et 122) à la fois à une deuxième extrémité (132) du barreau secondaire (13) d'une cellule élémentaire (10b ou 10c) qui, parmi lesdites au moins deux cellules élémentaires (10a, 10b et 10c), est adjacente à la cellule élémentaire (10a) considérée, et est destiné à être lié mécaniquement au bâti extérieur (3), et
   • le second barreau secondaire (13) de la cellule élémentaire (10a) considérée est lié mécaniquement par une première (131) de ses deux extrémités (131 et 132) à la seconde extrémité (112) du barreau primaire (11) de la cellule élémentaire (10a) considérée, est lié mécaniquement par une seconde (132) de ses deux extrémités (131 et 132) à la fois à une seconde extrémité (122) du premier barreau secondaire (12) d'une cellule élémentaire (10b ou 10c) qui, parmi lesdites au moins deux cellules élémentaires (10a, 10b et 10c), est adjacente à la cellule élémentaire (10a) considérée, et destiné à être lié mécaniquement au bâti extérieur (3).

12. Dispositif de maintien selon l'une quelconque des revendications précédentes, dans lequel le barreau tertiaire (14) de chaque cellule élémentaire (10a, 10b, 10c) est situé au droit et à distance du barreau primaire (11) de la cellule élémentaire (10a) considérée, et est destiné à être situé, relativement au pourtour extérieur ou intérieur du résonateur piézoélectrique (2) qu'il contribue à maintenir, à une plus grande distance que le barreau primaire (11) de la cellule élémentaire (10a) considérée.

13. Ensemble comprenant un dispositif de maintien (1) selon l'une quelconque des revendications précédentes et au moins un résonateur piézoélectrique (2).

14. Convertisseur de puissance comprenant un ensemble selon la revendication précédente.

15. Procédé de dimensionnement d'un dispositif de maintien (1) selon l'une quelconque des revendications 1 à 12, comprenant :

   • dimensionner au moins un, de préférence chaque, barreau primaire (11) d'au moins une, de préférence de chaque, cellule élémentaire (10a, 10b, 10c) de sorte que, avec un résonateur piézoélectrique (2) configuré pour vibrer dans une bande de fréquence déterminée, le barreau primaire (11) est en résonance, à 20% près, avantageusement à 10% près, avec les vibrations du résonateur piézoélectrique (2) pour une fréquence d'excitation quelconque située dans ladite bande de fréquence déterminée, et/ou

• dimensionner au moins l'un, de préférence chacun, parmi les premier et second barreaux secondaires (12 et 13) d'au moins une, de préférence de chaque, cellule élémentaire (10a, 10b, 10c) de sorte qu'il présente une longueur sensiblement égale à un multiple d'une demi-longueur d'onde pour une fréquence d'excitation choisie située dans la bande de fréquence déterminée, et de préférence en son centre ou son centre géométrique, et présentent, par rapport à leur axe longitudinal, un moment quadratique au moins quatre fois supérieur, de préférence au moins dix fois supérieur, à un moment quadratique du barreau primaire (11) par rapport à son axe longitudinal, et/ou

• dimensionner le barreau tertiaire (14) d'au moins une, de préférence de chaque, cellule élémentaire (10a, 10b, 10c), de sorte qu'il présente une longueur sensiblement égale à la longueur du barreau primaire (11) de la cellule élémentaire considérée, une épaisseur supérieure, de préférence au moins deux fois supérieure, à une épaisseur du barreau primaire (11) de la cellule élémentaire considérée, et est adapté en impédance mécanique avec les premier et second barreaux secondaires (12 et 13) de la cellule élémentaire considérée.

FIG. 1

FIG. 1A

FIG. 2

FIG. 3

FIG. 4

FIG. 5

Europäisches
Patentamt

European
Patent Office

Office européen
des brevets

# RAPPORT DE RECHERCHE EUROPEENNE

Numéro de la demande

EP 24 22 2410

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2010/314969 A1 (GAIDARZHY ALEXEI [US] ET AL) 16 décembre 2010 (2010-12-16) * figures 2, 5 * | 1-15 | INV. H03H9/05 H03H9/02 |
| X | US 8 947 176 B2 (HENTZ SEBASTIEN [FR]; ARCAMONE JULIEN [FR] ET AL.) 3 février 2015 (2015-02-03) * figures 1, 2 * | 1 | |
| X | US 10 778 182 B2 (MURATA MANUFACTURING CO [JP]) 15 septembre 2020 (2020-09-15) * figure 7 * | 1 | |
| A | CN 107 925 395 B (MURATA MANUFACTURING CO) 17 septembre 2021 (2021-09-17) * figure 4 * | 1-15 | |

DOMAINES TECHNIQUES
RECHERCHES (IPC)

H03H

Le présent rapport a été établi pour toutes les revendications

| Lieu de la recherche | Date d'achèvement de la recherche | Examinateur |
|---|---|---|
| Munich | 12 mai 2025 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................................

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 22 2410

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-05-2025

| Document brevet cité au rapport de recherche | Date de publication | Membre(s) de la famille de brevet(s) | Date de publication |
|---|---|---|---|
| US 2010314969 A1 | 16-12-2010 | US 2010314969 A1 | 16-12-2010 |
| | | WO 2010110918 A1 | 30-09-2010 |
| US 8947176 B2 | 03-02-2015 | EP 2441170 A1 | 18-04-2012 |
| | | FR 2946479 A1 | 10-12-2010 |
| | | US 2012092082 A1 | 19-04-2012 |
| | | WO 2010142643 A1 | 16-12-2010 |
| US 10778182 B2 | 15-09-2020 | AUCUN | |
| CN 107925395 B | 17-09-2021 | CN 107925395 A | 17-04-2018 |
| | | JP 6646899 B2 | 14-02-2020 |
| | | JP WO2017051573 A1 | 14-06-2018 |
| | | US 2018191329 A1 | 05-07-2018 |
| | | WO 2017051573 A1 | 30-03-2017 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1041714 A2

- CN 109546986

**Littérature non-brevet citée dans la description**

- **B.P. HARRINGTON et al.** In-plane acoustic reflectors for reducing effective anchor loss in lateral-extensional MEMS resonators. *J. Micromech. Microeng*, 2011, vol. 21, 085021